# EUROPEAN PATENT APPLICATION

(11) **EP 4 790 690 A1**
(43) Date of publication of application: **12.08.2026**
(21) Application number: 24874919.4
(22) Date of filing: 30.09.2024
(51) Int. Cl.: G09F 19/12, G09F 9/30, G06F 1/16, H10K 77/10, H10K 59/40, H10K 59/38, H10K 59/80, G09F 19/18, B60K 35/00

(54) **VEHICLE DISPLAY DEVICE AND OPERATING METHOD THEREOF**

(30) Priority: 06.10.2023 KR 20230133549
(71) Applicant: LG Electronics Inc., Yeongdeungpo-gu Seoul 07336 (KR)
(72) Inventor: KANG, Seungmo, Seoul 06772 (KR); KIM, Taeil, Seoul 06772 (KR); KIM, Hansoo, Seoul 06772 (KR); SHIM, Inkoo, Seoul 06772 (KR); DIBOINE, Romain, Seoul 06772 (KR)
(74) Representative: Vossius & Partner Patentanwälte Rechtsanwälte mbB
(86) International application number: PCT/KR2024/014833
(87) International publication number: WO 2025/075363

(57) **Abstract**

A vehicle display device is disclosed. The vehicle display device according to an embodiment of the present invention comprises: a housing in which a recessed inner space is formed; a display arranged above the inner space of the housing; a communication module for receiving state information from a vehicle; a first reflection module which is coupled to one side of the display in the inner space, and which is arranged such that a graphic emitted from a first area of the display is refracted to form a first screen area, and a second reflection module which is coupled to one side of the first reflection module, and which is arranged such that a graphic emitted from a second area of the display is reflected to form a second screen area; a viewing angle adjusting module arranged to correspond to the front surface of the display so as to adjust a viewing angle such that light emitted from the display is emitted within a predetermined angle range; and a processor. The processor controls, during driving of the display, the driving of the viewing angle adjusting module such that the viewing angles for the first and second screen areas are changed on the basis of the received state information.

## Description

### Technical Field

The present disclosure relates to a vehicular display device, and more specifically, to a vehicular display device configured to form a plurality of screens using graphic light emerging from a single display module.

### Background Art

A vehicle is an apparatus that transports a user in a direction desired by the user. A typical example of a vehicle is an automobile.

A trend has emerged in which vehicles are equipped with various sensors, electronic devices, and equivalents thereof to improve user convenience. Particularly, to enhance user convenience, extensive research has been conducted on Advanced Driver Assistance Systems (ADAS). Furthermore, the development of autonomous vehicles has been actively conducted.

The term 'autonomous driving' refers to a system in which a vehicle is capable of determining driving behavior and operating without input from an occupant. This autonomous driving may be categorized into progressive stages ranging from non-automation to full automation, depending on the degree to which the system is involved in driving and the extent to which a driver controls a vehicle.

Autonomous driving of vehicles has transformed the perception of vehicles from being merely a means of transportation to being a space where one can dwell. Moreover, a trend has emerged in which displays of ever-increasing size are mounted in vehicles to allow users to enjoy various infotainment content. In addition, research and development have been conducted to provide a more diverse usage environment when using the display.

### Disclosure of Invention

### Technical Problem

The objects of the present disclosure are to address the above-mentioned problems and other related problems.

According to some embodiments of the present disclosure, one object of the present disclosure is to provide a vehicular display device capable of providing a plurality of usage environments using a single display, and a method of operating the vehicular display device.

According to some embodiments of the present disclosure, another object of the present disclosure is to provide a vehicular display device capable of using, selectively or simultaneously, different types of usage environments formed through a single display, and a method of operating the vehicular display device.

According to some embodiments of the present disclosure, a further object of the present disclosure is to provide a vehicular display device capable of varying a position at which a 3D graphic floats according to a user's field of view, a content type, or content movement, and a method of operating the vehicular display device.

According to some embodiments of the present disclosure, another object of the present disclosure is to provide a vehicular display device capable of providing information displayed in different types of screens in such a manner as to protect the privacy of a driver in a driver's seat and a passenger in a front passenger seat, and a method of operating the vehicular display device.

According to some embodiments of the present disclosure, still another object of the present disclosure is to provide a vehicular display device capable of providing information displayed in different types of screens in such a manner as not to obstruct a driver's view and not to interfere with driving.

### Solution to Problem

To accomplish the above-mentioned objects, a vehicular display device according to an embodiment of the present disclosure is capable of adjusting fields of view for a plurality of screens generated by refracting or reflecting graphic light emerging from a single display through different reflective modules.

According to one aspect of the present disclosure, there is provided a vehicular display device including: a housing recessed to form an inner space inside; a display arranged in an upper portion of the inner space in the housing; a communication module receiving state information from a vehicle; a first reflective module coupled to one side of the display in the inner space and arranged in such a manner that graphic light emitted from a first region of the display forms a first screen region after refraction; a second reflective module coupled to one side of the first reflective module in the inner space and arranged in such a manner that graphic light emitted from a second region of the display forms a second screen region after reflection; and a field-of-view adjustment module arranged in a manner that corresponds to a front surface of the display, and adjusting a field of view in such a manner that light emitted from the display emerges within a predetermined range of angles; and a processor electrically coupled to the display, the first and second reflective modules, and the field-of-view adjustment module, and controlling each operation thereof. When operating the display, the processor controls the driving of the field-of-view adjustment module on the basis of the received state information in such a manner that fields of view for the first and second screen regions vary.

In an embodiment, in the vehicular display device, the first reflective module may include a prism, the second reflective may include a 3D plate that extends from one side of the prism and is arranged to face the display at a predetermined angle with respect to the display, and the field-of-view adjustment module may employ a structure that is coupled, as a type of partition or film, to the prism or the 3D plate.

In an embodiment, in the vehicular display device, the field-of-view adjustment module may include: a first field-of-view adjustment module, arranged on the 3D plate to correspond to a first sub-region corresponding to a driver's seat of the vehicle; and a second field-of-view adjustment module, arranged on the 3D plate to correspond to a second sub-region corresponding to a front passenger seat of the vehicle. The processor may control the first and second field-of-view adjustment modules on the basis of the received state information in such a manner that a field of view for each of the first and second sub-regions remains within a predetermined range of angles or reaches or exceeds the predetermined range of angles.

In an embodiment, in the vehicular display device, on the basis of the state information received from the vehicle, the processor may control the field-of-view adjustment module in a first vehicle state in such a manner that light emitted from the display emerges to reach or exceed the predetermined range of angles, and may control the field-of-view adjustment module in a second vehicle state in such a manner that the light emitted from the display emerges within the predetermined range of angles.

In an embodiment, in the vehicular display device, the state information received from the vehicle may include occupant information sensed through an internal camera of the vehicle, the first vehicle state may be a state in which an occupant in a front passenger seat of the vehicle is not detected, and the second vehicle state may be a state in which the occupant in the front passenger seat is detected.

In an embodiment, in the vehicular display device, the state information received from the vehicle may further include driving mode information of the vehicle, and the second vehicle state may be a state in which the vehicle operates in a manual driving mode.

In an embodiment, in the vehicular display device, the field-of-view adjustment module may include a plurality of transparent partitions formed on the display in a manner that is spaced apart by a predetermined distance, and the processor may determine, on the basis of the received state information, whether to drive the field-of-view adjustment module, and, based on the determination, may control the emerging of light within a predetermined range of angles by blocking side light emitted from the display using the plurality of transparent partitions.

In an embodiment, in the vehicular display device, the plurality of transparent partitions may comprise: a first transparent partition arranged between a first sub-region for a driver's seat and a second sub-region for sharing, in the second screen region; and a second transparent partition arranged between the second sub-region and a third sub-region for a front passenger seat in the second screen region

In an embodiment, in the vehicular display device, the processor may control the field-of-view adjustment module on the basis of the received state information in such a manner that at least one of the first and second transparent partitions blocks side light emitted from the display, thereby adjusting a field of view for at least one of the first and third sub-regions.

In an embodiment, in the vehicular display device, the field-of-view adjustment module may operate to adjust a field of view on the basis of voltage applied to a plurality of electrodes arranged on the display in such a manner that light emitted from the display emerges within a predetermined range of angles or emerges to reach or exceed the predetermined range of angles. The processor may determine, on the basis of the received state information, whether to block light that deviates from the predetermined angle range and, based on the determination, may control the application of varied voltage to a plurality of electrodes of the field-of-view adjustment module.

In an embodiment, in the vehicular display device, the processor may not apply voltage to the plurality of electrodes on the basis of the received state information in a first operation mode in which light deviating from the predetermined range of angles is blocked, and the processor may control the field-of-view adjustment module on the basis of the received state information in such a manner as to apply a preset voltage to the plurality of electrodes in a second operation mode in which the light deviating from the predetermined range of angles is not blocked.

In an embodiment, in the vehicular display device, the first and second screen regions may each be divided into a first sub-region for a driver's seat of the vehicle, a second sub-region for sharing, and a third sub-region for a front passenger seat of the vehicle. The field-of-view adjustment module may include a first plurality of electrodes for adjusting a field of view for the first sub-region, and a second plurality of electrodes for adjusting a field of view for the second sub-region.

In an embodiment, in the vehicular display device, the processor may control voltage to be applied to the first plurality of electrodes and the second plurality of electrodes on the basis of the received state information in such a manner that the fields of view for the first and second sub-regions are controlled.

### Advantageous Effects of Invention

A vehicular display device according to an embodiment of the present disclosure can execute a plurality of different display modes selectively or simultaneously using a single display module. For example, a real image or an aerial image may be displayed selectively or simultaneously using only a single display.

In addition, the vehicular display device according to an embodiment of the present disclosure can vary the position of a 3D virtual image that floats according to a content type or content movement, based on a user's field of view, thereby displaying a graphic image in such a manner that the 3D virtual image remains within a user's field of view and that a sense of immersion and a floating effect are maximized.

In addition, the vehicular display device in the present disclosure can selectively execute a privacy mode for the real and aerial images displayed in front of a driver's seat and a front passenger seat on the basis of a state of a vehicle.

Specifically, when an occupant in the front passenger seat is detected, and the display is in operation, the privacy mode can be executed for a plurality of screens displayed in front of the front passenger seat. In addition, during the manual driving of a vehicle, the privacy mode can be executed for a plurality of screens displayed in front of the front passenger seat to ensure that a driver's driving is not disturbed. In addition, during vehicle driving, for the protection of driver privacy, the privacy mode can also be executed for a plurality of screens displayed in front of the driver's seat. In this manner, fields of view for the driver's seat and the front passenger seat are adjusted to within a predetermined range or to reach or exceed the predetermined range, thereby protecting the user's privacy and providing various usage environments.

### Brief Description of Drawings

FIGS. 1 and 2 are block diagrams that are referenced to describe the configuration of a vehicle according to the present disclosure.
FIG. 3 is a view illustrating an example in which a vehicular display device according to the present disclosure operates after installation.
FIG. 4 is an exemplary block diagram that is referenced to describe the detailed configuration of the vehicular display device according to the present disclosure.
FIG. 5 is a perspective view illustrating the vehicular display device according to the present disclosure.
FIG. 6 is a cross-sectional view illustrating a state where a prism display region and a floating display region are formed when the vehicular display device according to the present disclosure operates, when viewed from the side.
FIG. 7 is an exemplary view that is referenced to describe a plurality of display regions in accordance with a display mode of the vehicular display device according to the present disclosure.
FIG. 8 is a view illustrating the vehicular display device arranged in a cluster or CID region of the vehicle according to the present disclosure, when viewed from the side.
FIG. 9 is an exemplary flowchart that is referenced to describe a method of operating the vehicular display device according to the present disclosure.
FIGS. 10, 11, and 12 are views illustrating exemplary structures of the vehicular display device, respectively, for executing a plurality of display modes using a single display, according to the present disclosure.
FIG. 13 is a view that is referenced to describe a method of changing the position of an AR image displayed in a floating display region in the vehicular display device according to the present disclosure.
FIG. 14 is an exemplary view that is referenced to describe the adjustment of respective fields of view of a prism region and a floating region that correspond to a driver's seat and a front passenger seat, respectively, in the vehicular display device according to the present disclosure.
FIGS. 15 and 16 are views that are referenced to describe a method of adjusting the fields of view for the prism region and the floating region through a partition-type field-of-view adjustment module according to an embodiment of the present disclosure.
FIGS. 17 and 18 are views that are referenced to describe a method of adjusting the fields of view for the prism region and the floating region through a film-type field-of-view adjustment module according to an embodiment of the present disclosure.
FIG. 19 is a view illustrating that a field of view for the driver's seat is adjusted through the vehicular display device according to the embodiment of the present disclosure.
FIG. 20 is a view illustrating that a field of view for the front passenger seat is adjusted through the vehicular display device.

### Mode for the Invention

Embodiments disclosed in the present specification will be described in detail below with reference to the accompanying drawings. The same reference numerals are used for the same or similar constituent elements, regardless of figure numbers, and redundant descriptions thereof are not repeated. The terms 'module' and 'unit' are hereinafter used interchangeably to name constituent elements solely for the convenience of description in the present specification. These terms are not intended to have different meanings or to indicate different functions. In addition, in describing the embodiments disclosed in the present specification, detailed descriptions of well-known related technologies may be omitted when such descriptions are deemed to obscure the nature and gist of the present disclosure. In addition, the accompanying drawings are merely provided to facilitate understanding of the embodiments disclosed in the present specification and shall not be construed as limiting the technical idea disclosed in the present specification. Furthermore, any modifications, equivalents, or substitutions of constituent elements, to the extent falling within the technical scope of the present disclosure, are intended to be encompassed within the scope of the present disclosure.

The ordinal numbers first, second, and so forth may be used to describe various elements, but they do not limit these elements. These terms are used merely to distinguish among constituent elements having similar functions.

It should be understood that a constituent element, when referred to as 'being connected to' or 'having access to' a different constituent element, may be directly connected to or have direct access to the different constituent element, or may be indirectly connected to or have access to the different constituent element through one or more intermediate constituent elements. Likewise, it should be understood that, when a constituent element is described as being 'connected to' or 'having access to' another constituent element, such connection or access may be direct without the need for one or more intermediary constituent elements.

A noun in singular form, unless clearly indicated otherwise by the context, shall be understood to include the plural form.

The terms 'include,' 'have,' and equivalent expressions, as used in the present application, shall be understood to indicate the presence of a feature, number, step, operation, constituent element, component, or combination thereof, without precluding the possibility of the presence or addition of one or more other features, numbers, steps, operations, constituent elements, components, or combinations thereof.

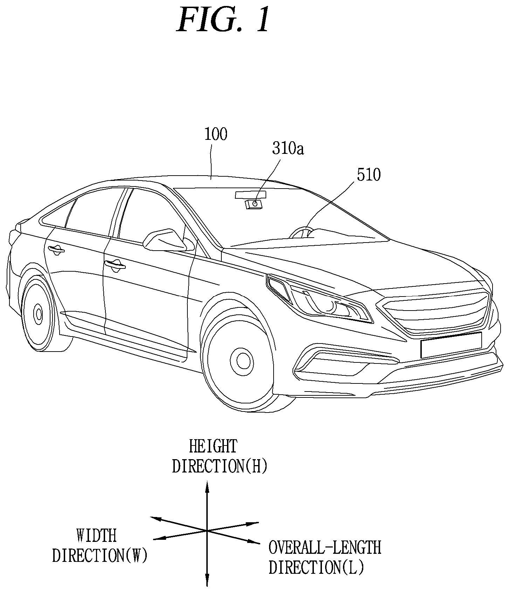

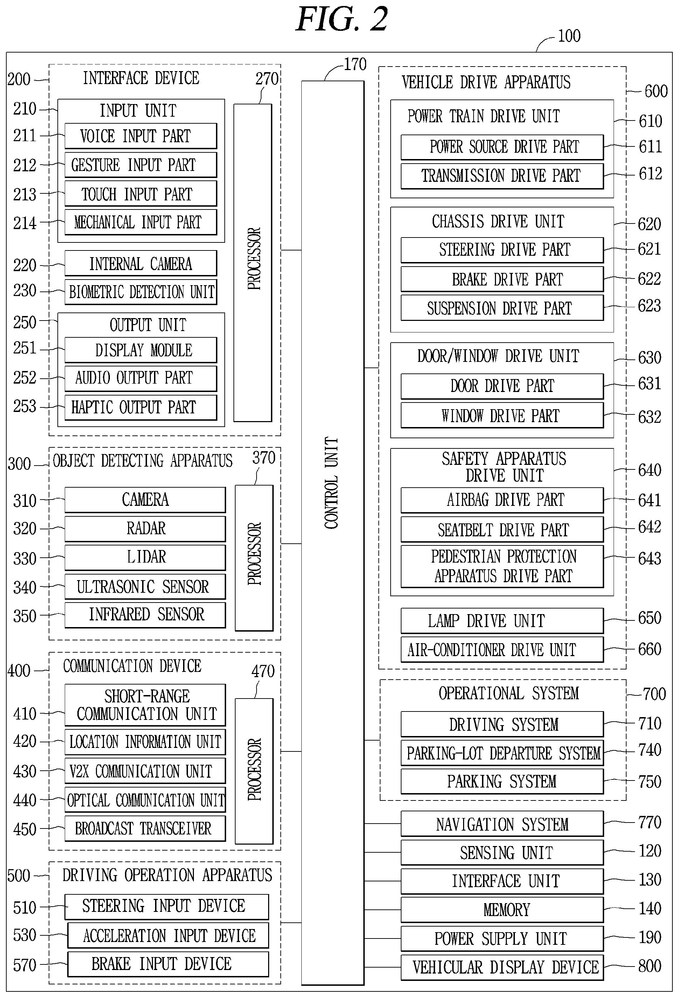

FIGS. 1 and 2 are exemplary block diagrams that are referenced to describe a vehicle according to the present disclosure and the configuration of the vehicle.

With reference to FIG. 1, a vehicle 100 may include wheels that are rotated by a power source and a steering input device 510 for adjusting the traveling direction of the vehicle 100.

The vehicle 100 may be an autonomous driving vehicle. The vehicle 100 may switch to an autonomous driving mode or a manual mode in response to a user input. For example, the vehicle 100 may switch from the manual mode to the autonomous driving mode or from the autonomous driving mode to the manual mode in response to the user input received through a user interface device 200 (hereinafter referred to as a 'user terminal').

The vehicle 100 may switch to the autonomous driving mode or the manual mode on the basis of driving situation information. The driving situation information may be generated on the basis of object information provided by an object detection device 300. For example, the vehicle 100 may switch from the manual mode to the autonomous driving mode or from the autonomous driving mode to the manual mode on the basis of the driving situation information generated by the object detection device 300. For example, the vehicle 100 may switch from the manual mode to the autonomous driving mode or from the autonomous driving mode to the manual mode on the basis of the driving situation information received through a communication device 400.

The vehicle 100 may switch from the manual mode to the autonomous driving mode or from the autonomous driving mode to the manual mode on the basis of information, data, or signals, each of which is provided by an external device.

In a case where the vehicle 100, which is an autonomous driving vehicle, may be driven in the autonomous driving mode, the vehicle 100 may be driven through the use of an operational system 700. For example, the autonomous driving vehicle 100 may be driven on the basis of information, data, or signals, each of which is generated by a driving system 710, a parking-lot departure system 740, or a parking system 750.

In a case where the vehicle 100, which is an autonomous driving vehicle, is driven in the manual mode, the vehicle 100 may receive a user input for driving through a driving operation apparatus 500. The vehicle 100 may be driven in response to the user input received through the driving operation apparatus 500.

The vehicle 100 may include the user interface device 200, the object detection devices 300, the communication device 400, the driving operation apparatus 500, a vehicle driving apparatus 600, the operational system 700, a navigation system 770, a sensing unit 120, a vehicular interface unit 130, a memory 140, a control unit 170, and a power supply unit 190.

According to an embodiment, the vehicle 100 may further include one or more constituent elements in addition to the constituent elements described in the present specification or may omit one or more of the described constituent elements.

The user interface device 200 is a device for communication between the vehicle 100 and the user. The user interface device 200 may receive the user input and may provide information, generated by the vehicle 100, to the user. The vehicle 100 may provide a user interface (UI) or user experience (UX) through the user interface device (hereinafter referred to as the 'user terminal') 200.

The user interface device 200 may include an input unit 210, an internal camera 220, a biometric detection unit 230, an output unit 250, and a processor 270. According to an embodiment, the user interface device 200 may further include one or more constituent elements in addition to the constituent elements described in the present specification or may omit one or more of the described constituent elements.

The input unit 210 serves to receive information as input from the user. The processor 270 may analyze data collected through the input unit 210 and may convert the data into a control command of the user.

The input unit 210 may be arranged within the vehicle 100. For example, the input unit 210 may be arranged in a region of the steering wheel, a region of the instrument panel, a region of the seat, a region of each pillar, a region of the door, a region of the center console, a region of the headlining, a region of the sun visor, a region of the windshield, a region of the window, or a region of a similar location.

The input unit 210 may include a voice input part 211, a gesture input part 212, a touch input part 213, and a mechanical input part 214.

The voice input part 211 may convert a user's voice input into an electrical signal. The electrical signal, resulting from the conversion, may be provided to the processor 270 or the control unit 170. The voice input part 211 may include one or more microphones.

The gesture input part 212 may convert a user's gesture input into an electrical signal. The electrical signal, resulting from the conversion, may be provided to the processor 270 or the control unit 170.

The gesture input part 212 may include at least one of the following: an infrared sensor or an image sensor, each of which serves to detect the user's gesture input. According to an embodiment, the gesture input part 212 may detect a user's three-dimensional (3D) gesture input. To this end, the gesture input part 212 may include a plurality of light-emitting units, each emitting an infrared ray, or a plurality of image sensors.

The gesture input part 212 may detect the user's 3D gesture input through a time-of-flight (TOF) technique, a structured light technique, or a disparity technique.

The touch input part 213 may convert the user's touch input into an electrical signal. The electrical signal, resulting from the conversion, may be provided to the processor 270 or the control unit 170.

The touch input part 213 may include a touch sensor for detecting the user's touch input. According to an embodiment, the touch input part 213 may be integrally formed with a display part 251, thereby forming a touch screen. The touch screen may provide both an input interface and an output interface between the vehicle 100 and the user.

The mechanical input part 214 may include at least one of the following: a button, a dome switch, a jog wheel, or a jog switch. An electrical signal generated by the mechanical input part 214 may be provided to the processor 270 or the control unit 170. The mechanical input part 214 may be arranged on a steering wheel, a center fascia, a center console, a cockpit module, a door, or an equivalent thereof.

The internal camera 220 may acquire an image of the interior of the vehicle 100. The processor 270 may detect the user's state on the basis of the image of the interior of the vehicle 100. The processor 270 may acquire the user's gaze information from the image of the interior of the vehicle 100. The processor 270 may detect the user's gesture from the image of the interior of the vehicle 100.

The biometric detection unit 230 may acquire the user's biometric information. The biometric detection unit 230 may include a sensor for acquiring the user's biometric information and may acquire the user's fingerprint information, heart rate information, and equivalents thereof using the sensor. The biometric information may be used for user authentication.

The output unit 250 may generate outputs associated with a visual sense, an auditory sense, a haptic sense, and the like. The output unit 250 may include at least one of the following: a display unit, an audio output unit 252, and a haptic output unit 253.

The term 'display unit' may be used to refer to a vehicular display device 800 according to the present disclosure or to a plurality of displays included in the vehicular display device 800. Alternatively, the vehicular display device 800 according to an embodiment of the present disclosure may also be included as one of the display units.

In addition, the term 'user interface device 200' may be interpreted as being functionally and structurally equivalent to the vehicular display device 800 according to the present disclosure. In this case, at least one constituent element included in the user interface device 200 in FIG. 1 may be interpreted as being functionally and structurally equivalent to at least one constituent element of the vehicular display device 800 in FIG. 2.

The display unit may display graphic objects that correspond to various pieces of information. The display module may include at least one of the following: a liquid crystal display (LCD), a thin-film transistor-LCD (TFT LCD), an organic light-emitting diode (OLED), a flexible display, a three-dimensional (3D) display, or an e-ink display.

The display unit may be configured to have a layered structure or an integrated structure with the touch input unit 213, thereby forming a touch screen.

The display unit may be configured as a head-up display (HUD). In a case where the display unit is configured as a HUD, the display unit may include a projection module, thereby outputting information through an image projected onto a windshield or a window.

The display unit may include a transparent display. The transparent display may be attached to the windshield or the window. The transparent display may have a predetermined degree of transparency and may output a predetermined screen thereon. To exhibit a degree of transparency, the transparent display may include at least one of the following: a thin-film electroluminescent (TFEL), a transparent organic light-emitting diode (OLED), a transparent liquid crystal display (LCD), a transmissive transparent display, or a transparent light-emitting diode (LED) display. The transparent display may have an adjustable level of transparency.

The user interface device 200 may include a plurality of display units. In this case, the plurality of display units may be positioned in various regions of the vehicle.

The audio output part 252 converts an electrical signal, provided from the processor 270 or the control unit 170, into an audio signal and outputs the audio signal. To this end, the audio output part 252 may include at least one speaker.

The haptic output part 253 generates a tactile output. For example, the haptic output unit 253 vibrates the steering wheel, the safety belt, or the seat, thereby enabling the user to perceive the tactile output.

The processor (hereinafter referred to as a 'control unit') 270 may control the overall operation of each unit of the user interface device 200. That is, the user interface device 200 may operate under the control of the control unit 170.

According to an embodiment, the user interface device 200 may include a plurality of processors 270 or may be configured without the processor 270.

In a case where the processor 270 is not included in the user interface device 200, the user interface device 200 may operate under the control of a processor of another apparatus within the vehicle 100, or under the control of the control unit 170.

The object detection device 300 is a device for detecting an object located outside the vehicle 100. This object may be an external entity associated with the driving of the vehicle 100. Examples of such an object include a lane, another vehicle, a pedestrian, a two-wheeled vehicle, a traffic signal, ambient light, a road, a structure, a speed bump, a terrain feature, an animal, and equivalents thereof.

The objects may be classified into movable objects and stationary objects. Examples of the movable objects may be conceptually represented as including another vehicle and a pedestrian. Examples of the stationary objects may be conceptually represented as including a traffic light, a road, and a structure.

The object detection device 300 may include a camera 310, a radar 320, a LiDAR 330, an ultrasonic sensor 340, an infrared sensor 350, and a processor 370.

According to an embodiment, the object detection device 300 may further include one or more constituent elements in addition to the constituent elements described in the present specification or may omit one or more of the described constituent elements.

The camera 310 may be located on an appropriate portion of the exterior of the vehicle to capture an image of the surroundings of the vehicle 100. The camera 310 may be a monocular camera, a stereo camera 310a, an around-view monitoring (AVM) camera 310b, or a 360-degree camera.

For example, the camera 310 may be arranged adjacent to a front windshield within the vehicle to acquire an image of the surroundings in front of the vehicle. Alternatively, the camera 310 may be arranged in the vicinity of the front bumper or the radiator grill.

For example, the camera 310 may be arranged adjacent to a rear glass pane within the vehicle to capture the image of the surroundings behind the vehicle. Alternatively, the camera 310 may be arranged adjacent to a rear bumper, a trunk, or a tailgate.

For example, the camera 310 may be arranged adjacent to at least one of the side windows within the vehicle to capture an image of the surroundings alongside the vehicle. Alternatively, the camera 310 may be arranged in the vicinity of a side mirror, a fender, or a door.

The camera 310 may provide an acquired image to the processor 370.

The radar 320 may include an electromagnetic wave transmission unit and an electromagnetic wave reception unit. The radar 320 may be configured based on a pulse radar method or a continuous wave radar method, in accordance with the principle of emitting a radio wave. The radar 320 may be configured based on a Frequency Modulated Continuous Wave (FMCW) method or a Frequency Shift Keying (FSK) method, each of which is among continuous wave radar methods determined according to the signal waveform.

The radar 320 may detect an object based on a time-of-flight (TOF) technique or a phase-shift technique through the use of electromagnetic waves and may determine the location of the object, the distance to the object, and the relative speed with respect to the object.

The radar 320 may be arranged at an appropriate position on the exterior of the vehicle 100 to detect an object that is located in front of, behind, or alongside the vehicle 100.

The LiDAR 330 may include a laser transmission unit and a laser reception unit. The LiDAR 330 may be configured based on the time-of-flight (TOF) technique or the phase-shift technique.

The LiDAR 330 may be configured as a drive-type or non-drive-type LiDAR.

In a case where the LiDAR 330 may be configured as a drive-type LiDAR, the LiDAR 330 may be rotated by a motor and may detect an object in the vicinity of the vehicle 100.

In a case where the LiDAR 330 may be configured as a non-drive-type LiDAR, the LiDAR 330 may detect, through light steering, an object located within a predetermined range of the vehicle 100. The vehicle 100 may include a plurality of non-drive-type LiDAR's 330.

The LiDAR 330 may detect an object based on the time-of-flight (TOF) technique or the phase-shift technique through the use of laser light and may determine the location of the object, the distance to the object, and the relative speed with respect to the object.

The radar 330 may be arranged at an appropriate position on the exterior of the vehicle 100 to detect an object that is located in front of, behind, or alongside the vehicle 100.

The ultrasonic sensor 340 may include an ultrasonic wave transmission unit and an ultrasonic wave reception unit. The ultrasonic sensor 340 may detect an object through the use of ultrasonic waves and may determine the location of the object, the distance to the object, and the relative speed with respect to the object.

The ultrasonic sensor 340 may be arranged at an appropriate position on the exterior of the vehicle 100 to detect an object located in front of, behind, or alongside the vehicle 100.

The infrared sensor 350 may include an infrared light transmission unit and an infrared light reception unit. The infrared sensor 340 may detect an object through the use of infrared light and may determine the location of the detected object, the distance to the detected object, and the relative speed with respect to the detected object.

The infrared sensor 350 may be arranged at an appropriate position on the exterior of the vehicle 100 to detect an object located in front of, behind, or alongside the vehicle 100.

The processor 370 may control the overall operation of each unit of the object detection device 300.

The processor 370 may detect and track an object on the basis of an acquired image. The processor 370 may perform operations, such as calculation of the distance to the object and calculation of the relative speed with respect to the object, through the use of an image processing algorithm.

The processor 370 may detect and track an object through the use of reflected electromagnetic waves, resulting from the reflection of emitted electromagnetic waves by the object. The processor 370 may perform operations, such as calculation of the distance to the object and calculation of the relative speed with respect to the object, through the use of electromagnetic waves.

The processor 370 may detect and track an object through the use of reflected laser beams, resulting from the reflection of emitted lasers by the object. The processor 370 may perform operations, such as calculation of the distance to the object and calculation of the relative speed with respect to the object, through the use of laser beams.

The processor 370 may detect and track an object through the use of reflected ultrasonic waves, resulting from the reflection of emitted ultrasonic waves by the object. The processor 370 may perform operations, such as calculation of the distance to the object and calculation of the relative speed with respect to the object, through the use of ultrasonic waves.

The processor 370 may detect and track an object through the use of reflected infrared light, resulting from the reflection of emitted infrared light by the object. The processor 370 may perform operations, such as calculation of the distance to the object and calculation of the relative speed with respect to the object, through the use of infrared light.

According to an embodiment, the object detection device 300 may include a plurality of processors 370 or may be configured without including the processor 370. The camera 310, the radar 320, the LiDAR 330, the ultrasonic sensor 340, and the infrared sensor 350 may include respective processors for individual operation.

In a case where the processor 370 is not included in the object detection device 300, the object detection device 300 may operate under the control of a processor of an apparatus within the vehicle 100, or under the control of the control unit 170.

The object detection device 300 may operate under the control of the control unit 170.

The communication device 400 is a device for performing communication with an external device. The external device here may be another vehicle, a mobile terminal, or a server.

To perform communication, the communication device 400 may include a transmission antenna, a reception antenna, and at least one of the following: a radio frequency (RF) circuit or an RF device, each of which is capable of implementing various communication protocols.

The communication device 400 may include a short-range communication unit 410, a location information unit 420, a V2X communication unit 430, an optical communication unit 440, a broadcast transceiver 450, and a processor 470.

According to an embodiment, the communication device 400 may further include one or more constituent elements in addition to the constituent elements in the present specification or may omit one or more of the described constituent elements.

The short-range communication unit 410 is a unit for short-range communication. The short-range communication unit 410 may support short-range communication using at least one of the following technologies: Bluetooth^{™}, Radio Frequency IDentification (RFID), Infrared Data Association (IrDA), Ultra-Wide Band (UWB), Zig Bee, Near Field Communication (NFC), Wireless-Fidelity (Wi-Fi), Wi-Fi Direct, or Wireless Universal Serial Bus (USB).

The short-range communication unit 410 may form short-range wireless area networks and may perform short-range communication between the vehicle 100 and at least one external device.

The location information unit 420 is a unit for acquiring location information of the vehicle 100. For example, the location information unit 420 may include a Global Positioning System (GPS) module or a Differential Global Positioning System (DGPS) module.

The V2X communication unit 430 is a unit for performing wireless communication with a server (Vehicle to Infrastructure (V2I)), with another vehicle (Vehicle to Vehicle (V2V)), or with a pedestrian (Vehicle to Pedestrian (V2P)). The V2X communication unit 430 may include an RF circuit capable of implementing protocols for communication with an infrastructure (V2I), communication between vehicles (V2V), and communication with a pedestrian (V2P).

The optical communication unit 440 is a unit for performing communication with the external device through the use of light. The optical communication unit 440 may include an optical transmission part for converting an electrical signal into an optical signal and transmitting the optical signal to the outside, and an optical reception part for converting a received optical signal into an electrical signal.

According to an embodiment, the optical transmission part may be integrally formed with a lamp included in the vehicle 100.

The broadcast transceiver 450 is a unit for receiving a broadcast signal from an external broadcast management server or transmitting a broadcast signal to the broadcast management server over a broadcast channel. The broadcast channel may refer to a satellite channel, a terrestrial channel, or both. The broadcast signal may include a TV broadcast signal, a radio broadcast signal, and a data broadcast signal.

The processor 470 may control the overall operation of each unit of the communication device 400.

According to an embodiment, the communication device 400 may include a plurality of processors 470 or may be configured without including the processor 470.

In a case where the processor 470 is not included in the communication device 400, the communication device 400 may operate under the control of a processor of another apparatus within the vehicle 100, or under the control of the control unit 170.

The communication device 400, together with the user interface device 200, may constitute a vehicular display device. In this case, the vehicular display device may be referred to as a telematics device or an Audio Video Navigation (AVN) device.

The communication device 400 may operate under the control of the control unit 170.

The driving operation apparatus 500 is an apparatus that receives a user input for driving.

In the manual mode, the vehicle 100 may be driven on the basis of a signal provided by the driving operation apparatus 500.

The driving operation apparatus 500 may include the steering input device 510, an acceleration input device 530, and a brake input device 570.

The steering input device 510 may receive an input regarding the traveling direction of the vehicle 100 from the user. The steering input device 510 is preferably formed in the form of a wheel, thereby enabling a steering input through the rotation of the wheel. According to an embodiment, the steering input device may also be formed in the shape of a touch screen, a touchpad, or a button.

The acceleration input device 530 may receive, from the user, an input for accelerating the vehicle 100. The brake input device 570 may receive, from the user, an input for decelerating the vehicle 100. The acceleration input device 530 and the brake input device 570 are preferably formed in the shape of a pedal. According to an embodiment, the acceleration input device or the brake input device may also be formed in the shape of a touch screen, a touchpad, or a button.

The driving operation apparatus 500 may operate under the control of the control unit 170.

The vehicle drive apparatus 600 is an apparatus that electrically controls the operation of various apparatuses within the vehicle 100.

The vehicle drive apparatus 600 may include a power train drive unit 610, a chassis drive unit 620, a door/window drive unit 630, a safety apparatus drive unit 640, a lamp drive unit 650, and an air-conditioner drive unit 660.

According to an embodiment, the vehicle drive apparatus 600 may further include one or more constituent elements in addition to the constituent elements described in the present specification or may omit one or more of the described constituent elements.

The vehicle drive apparatus 600 may include a processor. Units of the vehicle drive apparatus 600 may include respective processors for individual operation.

The power train drive unit 610 may control the operation of a power train apparatus.

The power train drive unit 610 may include a power source drive part 611 and a transmission drive part 612.

The power source drive part 611 may execute control of a power source of the vehicle 100.

For example, in a case where the power source of the vehicle is a fossil-fuel-based engine, the power source drive part 610 may execute electronic control of the engine. Accordingly, output torque and other parameters of the engine may be controlled. The power source drive part 611 may adjust the engine output torque under the control of the control unit 170.

For example, in a case where the power source of the vehicle is an electric-energy-based motor, the power source drive part 610 may execute control of the motor. The power source drive part 610 may adjust the rotational speed, torque, and other parameters of the motor under the control of the control unit 170.

The transmission drive part 612 may execute control of a transmission. The transmission drive gearbox part 612 may adjust the state of the transmission. The transmission drive part 612 may change the state of the transmission to Drive (D), Reverse (R), Neutral (N), or Park (P).

In a case where the power source of the vehicle is an engine, the transmission drive part 612 may adjust the engaged state of a gear in Drive (D).

The chassis drive unit 620 may control the operation of a chassis apparatus. The chassis drive unit 620 may include a steering drive part 621, a brake drive part 622, and a suspension drive part 623.

The steering drive part 621 may execute electronic control of a steering apparatus within the vehicle 100. The steering drive part 621 may change the traveling direction of the vehicle.

The brake drive part 622 may execute electronic control of a brake apparatus within the vehicle 100. For example, the brake drive part 622 may reduce the speed of the vehicle 100 by controlling the operation of the brakes provided on the wheels.

The brake drive part 622 may individually control each of the plurality of brakes. The brake drive part 622 may control the application of varying braking forces to the plurality of wheels.

The suspension drive part 623 may execute electronic control of a suspension apparatus within the vehicle 100. For example, in a case where a road surface is uneven, the suspension drive part 623 may reduce vibration of the vehicle 100 by controlling the suspension apparatus. The suspension drive part 623 may control each of the plurality of suspensions individually.

The door/window drive unit 630 may execute electronic control of a door apparatus or a window apparatus within the vehicle 100.

The door/window drive unit 630 may include a door drive part 631 and a window drive part 632.

The door drive part 631 may execute control of the door apparatus. The door drive part 631 may control the opening or closing of a plurality of doors included in the vehicle 100. The door drive part 631 may control the opening or closing of the trunk or the tailgate. The door drive part 631 may control the opening or closing of the sunroof.

The window drive part 632 may execute electronic control of the window apparatus. The window drive part 632 may control the opening or closing of a plurality of windows included in the vehicle 100.

The safety apparatus drive unit 640 may execute electronic control of various safety apparatuses within the vehicle 100.

The safety apparatus drive unit 640 may include an airbag drive part 641, a seat belt drive part 642, and a pedestrian protection apparatus drive part 643.

The airbag drive part 641 may execute electronic control of an airbag apparatus within the vehicle 100. For example, when a risk is detected, the airbag drive part 641 may control an airbag in such a manner that the airbag is deployed.

The seat belt drive part 642 may execute electronic control of a seat belt apparatus within the vehicle 100. For example, when a risk is detected, the seat belt drive part 642 may secure occupants seated in seats 110FL, 110FR, 110RL, and 110RR by tightening respective seat belts.

The pedestrian protection apparatus drive part 643 may execute electronic control of the hood lift and the pedestrian airbag. For example, when a collision with a pedestrian is detected, the pedestrian protection apparatus drive part 643 may control a hood and the pedestrian airbag in such a manner that the hood is lifted up and that the pedestrian airbag is deployed.

The lamp drive part 650 may execute electronic control of various lamp apparatuses within the vehicle 100.

The air-conditioner drive unit 660 may execute electronic control of an air conditioner within the vehicle 100. For example, when the temperature inside the vehicle 100 is high, the air-conditioner drive unit 660 may control the air conditioner to operate in such a manner as to supply cool air into the vehicle 100.

The vehicle drive apparatus 600 may include a processor. Units of the vehicle drive apparatus 600 may include respective processors for individual operation.

The vehicle drive apparatus 600 may operate under the control of the control unit 170.

The operational system 700 is a system that controls various driving functions of the vehicle 100. The operational system 700 may operate in the autonomous driving mode.

The operational system 700 may include the driving system 710, the parking-lot departure system 740, and the parking system 750.

According to an embodiment, the operational system 700 may further include one or more constituent elements in addition to the constituent elements described in the present disclosure or may omit one or more of the described constituent elements.

The operational system 700 may include a processor. Units of the operational system 700 may include respective processors for individual operation.

According to an embodiment, in a case where the operational system 700 may be implemented in software, the operational system 700 may also conceptually operate at a lower level than the control unit 170.

According to an embodiment, the operational system 700 may conceptually include at least one of the following: the user interface device 200, the object detection device 300, the communication device 400, the vehicle drive apparatus 600, or the control unit 170.

The driving system 710 may enable the vehicle 100 to be driven.

The driving system 710 may receive navigation information from the navigation system 770, may provide a control signal to the vehicle drive apparatus 600, and may enable the vehicle 100 to be driven. The driving system 710 may receive object information from the object detection device 300, may provide a control signal to the vehicle drive apparatus 600, and may enable the vehicle 100 to be driven. The driving system 710 may receive a signal from an external device through the communication device 400, may provide a control signal to the vehicle drive apparatus 600, and may enable the vehicle 100 to be driven.

The parking-lot departure system 740 may perform a maneuver to guide the vehicle 100 out of a parking lot.

The parking-lot departure system 740 may receive the navigation information from the navigation system 770, may provide a control signal to the vehicle drive apparatus 600, and may perform a maneuver to guide the vehicle 100 out of the parking lot. The parking-lot departure system 740 may receive object information from the object detection device 300, may provide a control signal to the vehicle drive apparatus 600, and may perform a maneuver to guide the vehicle 100 out of the parking lot. The parking-lot departure system 740 may receive a signal from an external device through the communication device 400, may provide a control signal to the vehicle drive apparatus 600, and may perform a maneuver to guide the vehicle 100 out of the parking lot.

The parking system 750 may perform a maneuver to park the vehicle 100.

The parking system 750 may receive the navigation information from the navigation system 770, may provide a control signal to the vehicle drive apparatus 600, and may perform a maneuver to park the vehicle 100. The parking system 750 may receive object information from the object detection device 300, may provide a control signal to the vehicle drive apparatus 600, and may perform a maneuver to park the vehicle 100. The parking system 750 may receive a signal from an external device through the communication device 400, may provide a control signal to the vehicle drive apparatus 600, and may perform a maneuver to park the vehicle 100.

The navigation system 770 may provide the navigation information. The navigation information may include at least one of the following: map information, information about a preset destination, path information based on the preset destination, information about various objects on a path, lane information, or current vehicular location information.

The navigation system 770 may include a memory and a processor. The navigation information may be stored in the memory. The processor may control the operation of the navigation system 770.

According to an embodiment, the navigation system 770 may update previously stored information by receiving information from an external device through the communication device 400.

According to an embodiment, the navigation system 770 may also be classified as a sub-constituent element of the user interface device 200.

The sensing unit 120 may sense a state of the vehicle. The sensing unit 120 may include a posture sensor (e.g., a yaw sensor, a roll sensor, or a pitch sensor), a collision sensor, a wheel sensor, a speed sensor, a tilt sensor, a weight-detection sensor, a heading sensor, a yaw sensor, a gyro sensor, a position module, a vehicle forward/backward movement sensor, a battery sensor, a fuel sensor, a tire sensor, a steering sensor sensing the turning of a steering wheel, an in-vehicle temperature sensor, an in-vehicle humidity sensor, an ultrasonic sensor, an illumination sensor, an accelerator position sensor, a brake pedal position sensor, and other sensors.

The sensing unit 120 may acquire vehicular posture information, vehicular collision information, vehicular direction information, vehicular location information (GPS information), vehicular angle information, vehicular speed information, vehicular acceleration information, vehicular tilt information, vehicular forward/backward movement information, battery information, fuel information, tire information, vehicular lamp information, in-vehicle temperature information, and in-vehicle humidity information. Furthermore, the sensing unit 120 may acquire signals that result from sensing a steering wheel rotation angle, vehicle exterior illumination, pressure applied to an acceleration pedal, pressure applied to a brake pedal, and equivalents thereof.

The sensing unit 120 may further include an acceleration pedal sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), and other sensors.

The vehicular interface unit 130 may serve as an interface for various types of external devices connected to the vehicle 100. For example, the vehicular interface unit 130 may include a port that enables a connection to a mobile terminal and may be connected to the mobile terminal through the port. In this case, the vehicular interface unit 130 may exchange data with the mobile terminal.

The vehicular interface unit 130 may serve as an interface for supplying electrical energy to the connected mobile terminal. In a case where the mobile terminal is electrically connected to the vehicular interface unit 130, the vehicular interface unit 130 may supply electrical energy, supplied from the power supply unit 190, to the mobile terminal under the control of the control unit 170.

The memory 140 is electrically connected to the control unit 170. Basic data for the units, control data for controlling operations of the units, and input and output data may be stored in the memory 140. Examples of the memory 140 may include various hardware storage devices, such as ROM, RAM, EPROM, flash memory, and a hard disk drive. Programs and equivalents thereof for processing or control by the control unit 170 and various data for the overall operation of the vehicle 100 may be stored in the memory 140.

According to an embodiment, the memory 140 may be integrally formed with the control unit 170 or may be configured as a sub-constituent element of the control unit 170.

The control unit 170 may control the overall operation of each unit within the vehicle 100. The control unit 170 may be referred to as an Electronic Control Unit (ECU).

The power supply unit 190 may supply power necessary for the operation of each constituent element under the control of the control unit 170. Specifically, the power supply unit 190 may be supplied with power from the battery within the vehicle 100 or from other sources.

At least one processor and at least one control unit 170, which are included in the vehicle 100, may be configured based on at least one of the following: application-specific integrated circuits (ASICs), digital signal processors (DSPs), digital signal processing devices (DSPDs), programmable logic devices (PLDs), field-programmable gate arrays (FPGAs), processors, controllers, microcontrollers, microprocessors, or electric units performing other functions.

The vehicular display device 800 according to the present disclosure may form an aerial image and a real image in a plurality of different types of screen regions using a single display module. In addition, through the combination of a plurality of screen regions, a multi-display effect can be achieved using a single display module.

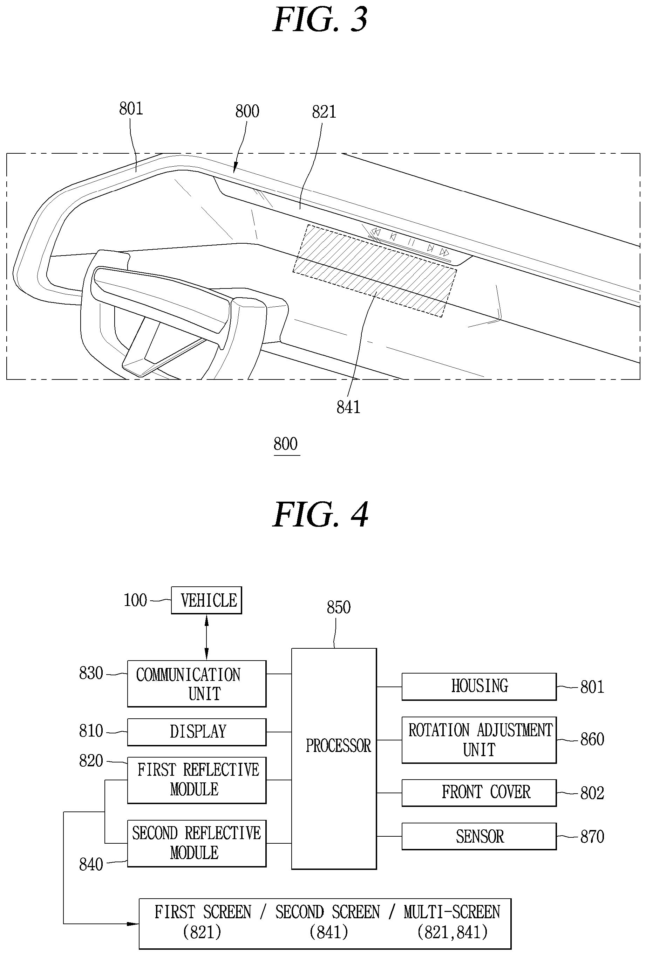

FIG. 3 is a view illustrating an example in which the vehicular display device 800 according to the present disclosure operates after installation.

The vehicular display device 800 may be installed in such a manner as to correspond to the dashboard in front of a driver's seat of the vehicle 100, or may be installed in a rectangular shape extending from the dashboard in front of the driver's seat to a front passenger seat.

The vehicular display device 800 includes a housing 801 recessed to have an inner space, and a display may be arranged on one side of the inner space of the housing 801. For example, the display of the vehicular display device 800 may be arranged in an upper portion of the inner space in the housing 801, with a front surface of the display facing downward.

The housing 801 is formed to be recessed inward to have an inner space, thereby naturally forming a dark space. Accordingly, real and virtual images may be more clearly displayed on first and second screen regions formed by first and second reflective modules 820 and 840, respectively.

The housing 801 may be formed such that the inner side of the inner space is closed and the outer side facing the driver's seat is open. In addition, the housing 801 may be formed such that the inner space decreases in width as it extends inward and increases in width as it extends outward.

A plurality of screen regions may be formed in the inner space in the housing 801 by operating the display. In an embodiment, some of the plurality of screen regions may be formed to extend outward from the housing 801.

The plurality of screen regions may include a first screen region 821 formed in the upper portion of the inner space in the housing 801 and a second screen region 841 under the first screen region 821.

The first screen region 821 is a prism screen region that is formed by a graphic displayed in a region of the display undergoing refraction through a prism, and a real image may be displayed on the first screen region 821. In addition, the second screen region 841 is a floating screen region in which a graphic displayed in another region of the display is formed after reflection through a 3D plate, and an aerial image may be output on the second screen region 841.

In the prism screen region, for example, a real image, resulting from polarized light refracted through a prism being reflected by a mirror, may be displayed above the prism. In addition, a 3D aerial image (AR) based on graphic light of the display that is reflected by the 3D plate may be displayed in the inner space of the recessed housing 801 or may be displayed with at least one portion thereof extending outward from the inner space. In the former case, the prism screen region and the floating screen region are arranged on the same plane, whereas in the latter case, these screen regions may not be arranged on the same plane.

The first screen region 821 may be formed only at a position corresponding to the driver's seat or may be formed to correspond to the driver's seat and the front passenger seat. The second screen region 841 may be formed at a position corresponding to the driver's seat and the front passenger seat.

The first screen region 821 and the second screen region 841 may be selectively formed or simultaneously formed. In a case where the first and second screen regions 821 and 841 are formed together, associated content items may be displayed as different types of images, for example, as a real image and an aerial image.

FIG. 4 is an exemplary block diagram that is referenced to describe the detailed configuration of the vehicular display device 800 according to the present disclosure.

The vehicular display device 800 may include a housing 801, a display 810, a communication unit 830, a first reflective module 820, a second reflective module 840, a processor 850, a rotation adjustment unit 860, and a sensor 870. In addition, the vehicle control device 800 may communicate with the vehicle 100 through the communication unit 830. In addition, the vehicular display device 800 may be configured to form the first screen region 821, the second screen region 841, and/or the multi-screen region indicated by 821 and 841 through the first reflective module 820 and/or the second reflective module 840.

The housing 801 constitutes a frame of the vehicular display device 800 and is formed to be recessed to form an inner space inside.

The display 810 may be arranged on one side of the inner space in the housing 801, for example, in the upper portion of the inner space. At this point, a rear surface of the display 810 is coupled to a ceiling of the inner space in the housing 801, and a front surface of the display 810 may be arranged to face the floor.

The display 810 may be arranged to be inclined at a predetermined angle in such a manner as not to be parallel to the floor. To this end, the ceiling of the inner space in the housing 801 may be formed to be inclined at a predetermined angle relative to the floor. In this manner, the display 810 is formed to be inclined at a predetermined angle relative to the floor. Thus, a floating effect of the 3D AR image displayed in the second screen region formed through the second reflective module 840 is further maximized.

The communication unit 830 may receive data, which is related to the state of the vehicle and the driving of the vehicle, from the vehicle 100 in which the vehicular display device 800 is installed. In addition, the communication unit 830 may transmit an operational state of the vehicular display device 800 and data related to the operation of the vehicular display device 800 to the vehicle 100. To this end, the communication unit 830 may be configured to include both a transmission module and a reception module or to include a transceiver capable of both transmission and reception.

The first reflective module 820 may be arranged to be coupled to one side of the display 810 in the inner space in the housing 801. The first reflective module 820 may be arranged in such a manner that graphic light emitted from a first region of the display 810 undergoes refraction to form the first screen region. The first screen region refers to a prism region in which a real image of linearly polarized light is displayed, the linearly polarized light corresponding to a graphic of the display 810 that undergoes refraction through the prism. The 'first screen region' may be hereinafter referred to as a 'prism display,' a 'prism screen,' or a 'prism screen region.'

The first reflective module 820 may include a prism and a reflection plate to form the first screen region. The first screen region may be formed above the second screen region described below, and the graphic light emitted from the first region of the display 810 may be output as a real image.

The second reflective module 840 may be arranged to be coupled to one side of the first reflective module 820 in the inner space in the housing 801. The second reflective module 840 may be arranged such that graphic light emitted from the second region of the display 810 is reflected to form the second screen region. The second screen region is connected to the first screen region and defines an AR floating region in which a virtual (AR) image is displayed in the inner space in the housing 801. The 'second screen region' may be referred to as a 'floating region,' a 'floating screen,' 'a floating display,' a 'floating screen region,' an 'aerial-image screen region,' or an 'AR floating region.'

The second reflective module 840 may include a 3D plate and a reflection plate to form the second screen region. At this point, the second screen region may be formed below the first screen region. Thus, graphic light emitted from the second region of the display 810 may be output as an aerial image, that is, as a 3D AR image.

The processor 850 generally operates the display 810, the first reflective module 820, and the second reflective module 840. The processor 850 may be arranged on an inner side of the inner space in the housing 801 or on an outer side of a rear surface of the housing 801.

The processor 850 may control whether to operate the display 810 based on the startup of the vehicle or on a request. When operating the display 810, by controlling the operation of the first reflective module 820 and/or the second reflective module 840, the processor 850 may control the display 810 in such a manner that a graphic displayed on the display 810 appears as a real image or an aerial image through the first screen region and/or the second screen region.

When operating the display 810, the processor 850 may control at least one of the first and second reflective modules 820 and 840 according to a preset condition. By doing so, the processor 850 may determine whether to activate the first and second screen regions. Accordingly, an occupant in the vehicle 100 may view a graphic displayed through the display 810 at the first screen region, the second screen region, or the multi-screen region.

The processor 850 may control a change in the position of the second screen region formed through the second reflective module 840 by controlling the operation of the rotation adjustment unit 860. The rotation adjustment unit 860 may also be implemented as a function of the processor 850.

The rotation adjustment unit 860 may control the rotation of the second reflective module 840 in such a manner as to change a reflection angle and an optical path length between the second reflective module 840 and the display 810. To this end, the second reflective module 840 may be rotatably coupled to a rotation driving unit at one side of the rotation adjustment part 860.

The rotation of the second reflective module 840 may be adjusted in accordance with the operation of the rotation adjustment unit 860, thereby enabling the position of the second screen region formed through the second reflective module 840 to be varied. Accordingly, a 3D virtual image displayed in the second screen region may move backward or forward.

The rotation adjustment unit 860 may be configured to include a coupling unit for coupling to the second reflective module 860, a rotation unit for rotating the second reflective module 860, and a support unit for supporting a plate during the rotation of the second reflective module 860.

The sensor 870 may include a sensor for detecting an input to the display 810 and a sensor for detecting a (hovering) input to the first and second screen regions. In addition, the sensor 870 may further include a camera sensor, an IR sensor, an IMS sensor, and the like for recognizing an entity performing an input or monitoring a state of an occupant in the driver's seat or the front passenger seat.

In some embodiments, the sensor 870 may include a camera sensor, an IR sensor, and an IMS sensor for the vehicle. The vehicular display device 800 may recognize an occupant's field of view through the sensor 870 and may transmit information about the occupant's field of view to the processor 850. Then, the processor 850 may adjust a position where the second screen region is formed, by changing the position of the second reflective module 840 based on the occupant's field of view.

The vehicular display device 800 may further include a front cover 802. In this case, the front cover 802 may be closed to conceal the inner space in the housing 801 from being visible when the display 810 is not in operation, and may operate to expose the inner space in the housing 801 when the display 810 is in operation.

In this manner, the vehicular display device 800 according to an embodiment of the present disclosure refracts a portion of a graphic emerging from one display 810 arranged on one side of the inner space in the housing 801 through the first reflective module, and reflects another portion through the second reflective module. By doing so, the vehicular display device 800 may realize complex content including an aerial image and a real image selectively or simultaneously, using a single display module.

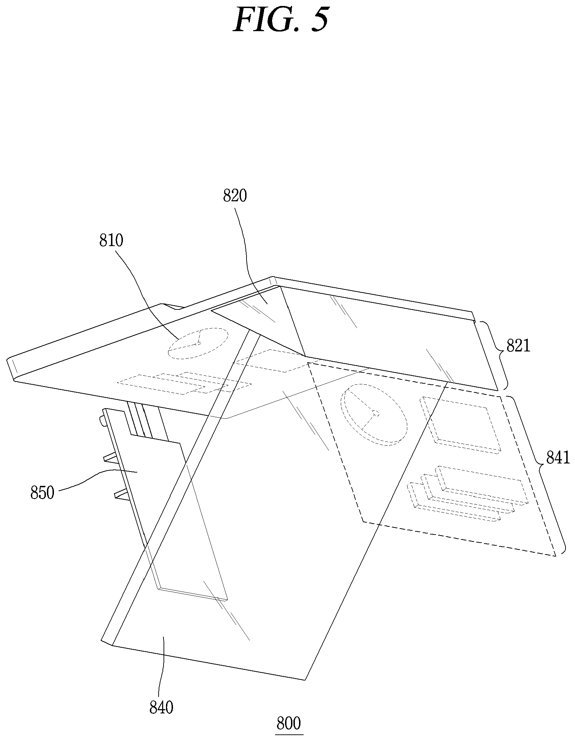

FIG. 5 is a perspective view illustrating the vehicular display device 800 according to the present disclosure. Specifically, FIG. 5 is a view illustrating one 'package' configuration of the vehicular display device 800 for outputting a graphic displayed on a single display, arranged in an upper portion, through the prism screen and the floating screen, when viewed from the side.

A display 810, inclined at a predetermined angle relative to the floor, may be arranged in an upper portion of the package. That is, the display 810 may be arranged in the upper portion in a manner tilted at a predetermined angle so as not to be parallel with the floor. Accordingly, the floating effect of the 3D virtual image displayed in the floating region formed through the second reflective module 840 described below may be expressed in a more three-dimensional and prominent manner. In addition, by arranging the front surface of display 810 to face the floor, light-emitting graphic light emerges from the front surface of display 810 in a vertical direction when the display 810 is in operation.

The processor 850, for example, a PCB, for controlling the operation of the vehicular display device 800 is arranged at the rear side of the package. The processor 850 controls the operation of the display 810, the activation and the deactivation of the first and second reflective modules 820 and 840, and the operation thereof. The processor 850 may be electrically coupled to one side of the display 810 and may be arranged to be positioned perpendicularly to the display 810 arranged in the upper portion.

The first reflective module 820 may operate to refract graphic light emerging from a region of the display 810 through a prism coupled vertically to one side of the display 810, thereby displaying a real image on the prism.

A prism of the first reflective module 820 is a refractive body fabricated from a transparent transmissive material at precise angles and planes. The prism changes an optical path by redirecting graphic light output to the first region of the display 810. The prism of the first reflective module prism 820 is arranged to be positioned perpendicularly to the display 810, and, for example, may have the shape of a triangular prism. Accordingly, the graphic light output to the first region of the display 810 is refracted, and consequently, the first screen region (or the prism region) 821 may be formed on a surface of a prism that is positioned perpendicularly to the display 810. In an embodiment, depending on the number of reflective mirrors coupled to the prism, an image of a graphic output to the first of the display 810 is either inverted or displayed in the same shape in the first screen region.

The second reflective module 840 includes the 3D plate that is coupled to one side of the first reflective module 820 and is arranged to be positioned at a predetermined angle with respect to the display 810. The 3D plate, for example, a 3D hologram plate, may reflect graphic light emerging from another region of the display 810, for example, the second region, thereby displaying an aerial image, that is, a 3D virtual image, at a position corresponding to the occupant's field of view.

At this point, the first screen region, formed through the first reflective module 820, and the second screen region, formed through the second reflective module 840, have different depths. Specifically, the first screen region 821 is formed on a front surface of the prism of the first reflective module 820, whereas the second screen region 841 is formed in a 3D space that is formed by reflection through the 3D plate of the second reflective module 840. At this point, a portion of the second screen region may be positioned on the same plane as the first screen region.

The package may be arranged within the housing 801 (FIG. 4) recessed to form an inner space. Along with the housing structure 801, the second reflective module 840 reflects graphic light emitted from the display 810 through the 3D hologram plate, thereby forming an image at the lower end portion. This inherently obstructs external light.

Although not illustrated, the package may further include a light absorption unit for absorbing the graphic light emerging from the display 810, and a backplate coupled to a rear surface of the 3D plate of the second reflective module 840.

At this point, a material of the backplate may be an ultra-thin glass (UTG) and can perform a function of supporting the 3D hologram plate from the rear surface.

In addition, the light absorption unit is arranged to form a darkroom on the left and right sides of the housing 801 and may absorb light resulting from the graphic light emitted from the display 810 being scattered by reflection. The light absorption unit reduces the reflection luminance of the graphic light, thereby improving the contrast ratio of the 3D virtual image displayed on the second screen region 841.

The processor 850 of the package may control the second reflective module 840 in such a manner that the 3D plate thereof is rotated to change an inclination angle between the 3D plate and the display 810. The position of the 3D virtual image displayed in the second screen region 841 may be changed based on the change in the angle between the 3D plate of the second reflective module 840 and the display 810, the change being induced by the rotation of the 3D plate. To this end, one side of the second reflective module 840 is coupled to the rotation adjustment unit 860 (FIG. 4) so that the second reflective module 840 may be driven in response to a signal transmitted from the processor 850 in such a manner as to rotate the 3D plate thereof.

In some embodiments, the package may have a rotatable structure or include a driving cover such that the configuration of the package is in a closed state when the display 810 is not in operation and that at least one of the first and second screen regions 821 and 841 formed through the first and second reflective modules 820 and 840, respectively, may be exposed when the display 810 is in operation.

Subsequently, with reference to FIG. 5, the package is arranged within the housing 801 recessed to form an inner space in such a manner that the floating region formed through the second reflective module 840 may be displayed within the inner space.

In addition, as described above, a portion of the floating region that has a changed position when the 3D plate of the second reflective module 840 is rotated may be displayed outward from the inner space formed by the recess of the housing 801. Accordingly, a portion of the 3D floating content displayed in the floating region may be image-formed outward from the inner space formed by the recess of the housing 801.

The vehicular display device 800 reflects/refracts the graphic light emitted from the display 810, arranged in the upper portion, through the prism and the 3D plate that are the first and the second reflective modules 820 and 840, respectively, thereby forming a 3D aerial image and a 3D real image at a prism region 821 and a floating region 841, respectively. Consequently, the real image and the aerial image may be realized independently or simultaneously using a single display.

The graphic light emitted from the display 810 may be refracted through one or more lenses and prisms to form an eye box. To this end, an incident optical module for forming a curvature and an optical path may be further included. For example, a lens and a prism may be arranged at a predetermined angle (e.g., a right angle) relative to the display so as to have a curvature and an optical path for forming an eye box for a graphic displayed in the first region of the display 810.

In addition, the graphic light emitted from the display 810 may be reflected through the 3D plate and the reflective mirror, thereby forming an eye box for displaying an aerial image. At this point, the combiner for compensating for chromatic aberration and adjusting a focal length may be coupled. The combiner may include a 3D plate, which serves to reflect the emitted graphic light refracted through the prism, and a reflective mirror. An example of the 3D plate is a 3D hologram plate.

At this point, the reflective mirror may be configured in the form of a flat plate or a film. A reflective surface of the reflective mirror is formed on a portion of a front surface of the 3D plate, the portion facing the user's eyes, thereby compensating for the chromatic aberration and adjusting the focal length. In addition, according to the present disclosure, since the graphic light of the display 810 arranged in the upper portion of the package is emitted to the 3D plate either after being refracted through the prism or directly, the chromatic aberration due to the separation of a wavelength hardly occurs.

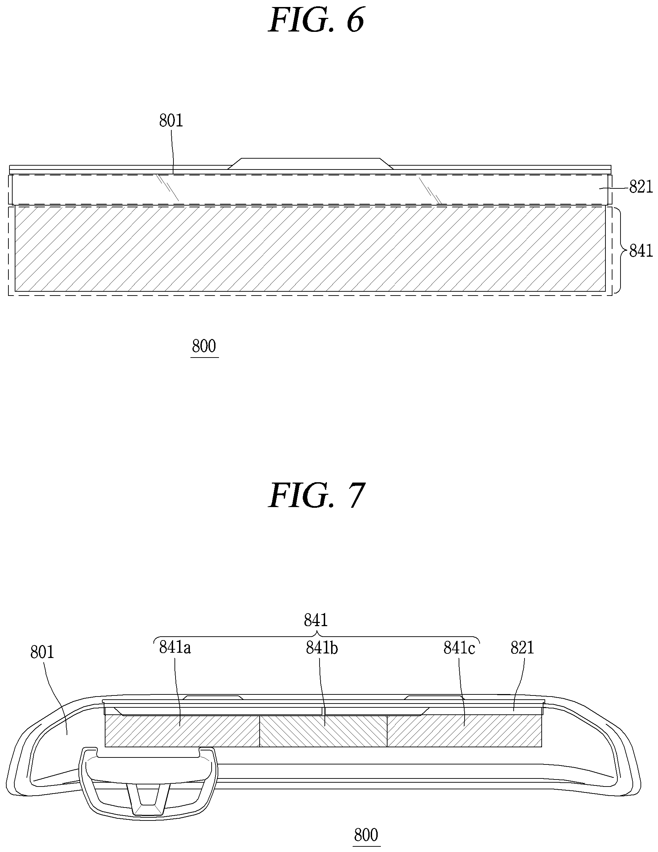

FIG. 6 is a view illustrating a state where the prism display region 821 and the floating display region 841 are formed when the vehicular display device 800 is in operation, when viewed from the side.

As illustrated in FIG. 6, the prism display region 821 may be formed in the upper portion of the inner space formed by the recess of the housing 801, and the floating display region 841 may be formed in the lower portion of the inner space formed by the recess of the housing 801.

The floating display region 841 may be formed to have a greater size than the prism display region 821. A real image may be displayed on the prism display region 821, and an aerial image having depth, that is, a 3D AR image, may be displayed on the floating display region 841.

The prism display region 821 and the floating display region 841 may be used selectively or may operate simultaneously.

To this end, when operating the display 810, the processor 850 of the vehicular display device 800 controls the operation of at least one of the first and second reflective modules 820 and 840 according to a preset condition. By doing so, the processor 850 may determine whether to activate the first and second screen regions, that is, the display region 821 and the floating display region 841.

At this point, the predetermined condition is associated with a driving state of the vehicle 100 in which the vehicular display device 800 is installed. For example, the predetermined conditions may correspond to various situations where a warning or alarm is required based on the driving state of the vehicle.

The processor 850 may activate the first reflective module 820 based on information related to the vehicle driving state, the information being received through the communication unit 830, while the vehicle is in a first driving state, thereby displaying a vehicle driving situation in the prism display region 821.

At this point, the first driving state refers to a normal driving state after vehicle ignition, representing a general driving situation where no warning or alarm is required.

Subsequently, when the vehicle transitions from the first driving state to a second driving state according to the information related to the vehicle driving state, the information being received through the communication unit 830, the first and second reflective modules 820 and 840 may be both activated. By doing so, the first and second reflective modules 820 and 840 may be controlled in such a manner that the vehicle driving situation is displayed together in the prism display region 821 and the AR floating display region 840.

At this point, the second driving state refers to a state where a driving situation, requiring a warning or alarm, occurs during vehicle driving. For example, the processor 850 may initiate a transition to the second driving state in a case where a warning or alarm is necessary due to the vehicle's regulation speed violation, a sharp curve ahead, or the appearance of an object around the vehicle. Furthermore, when the situation is cleared, the processor 850 may initiate a transition back to the first driving state.

In addition, according to the information related to the vehicle driving state, the information being received through the communication unit 830, the second reflective module 840 may be activated while the vehicle 100 is in a third driving state. By doing so, the second reflective module 840 may be controlled in such a manner that the AR virtual image is displayed in the AR floating display region 840 and that a graphic object related to the AR virtual image is displayed in the prism display region 821.

At this point, the third driving state may refer to a state where an entertainment function is performed while the vehicle is in a stopped state.

In another embodiment, the processor 850 of the vehicular display device 800 may determine to display one or both of the prism display region 821 and the AR floating display region 840, depending on the type of content to be output to the display 810. For example, the type of content related to a state of the vehicle may be displayed on the prism display region 821, and the type of entertainment content may be displayed in the AR floating display region 840.

In addition, in another embodiment, the processor 850 of the vehicular display device 800 may determine to display one or both of the prism display region 821 and the AR floating display region 840 based on the user's input or request.

As described above, the vehicular display device 800 according to the embodiment of the present disclosure may selectively provide a usage environment of a plurality of displays using a single display.

FIG. 7 is an exemplary view that is referenced to describe a plurality of display regions in accordance with a display mode of the vehicular display device 800.

According to a preset condition, the vehicular display device 800 may operate in a 'prism display mode' to display a real image in the prism screen region, may operate in a 'floating display mode' to display an aerial image in the floating screen region, or may operate in a 'multi-display mode' to simultaneously display a real image and an aerial image in the prism screen region and the floating screen region, respectively.

At this point, as described above, the preset condition may be related to the driving state of the vehicle, may be associated with the type of content to be image-formed, or may correspond to the user's input or request.

The vehicular display device 800 may control the second reflective module 840 in such a manner that the floating screen region 841 formed through the second reflective module 840 is displayed, in the inner space formed by the recess of the housing 801, at a position corresponding to each of the driver's seat and the front passenger seat.

Specifically, with reference to FIG. 7, the floating screen region 841 may be divided into a first floating region 841a, positioned to correspond to the driver's seat, a third floating region 841c, positioned to correspond to the front passenger seat, and a second floating region 841b, positioned to correspond to the space between the driver's seat and the front passenger seat.

The first floating region 841a may be a region used by an occupant in the driver's seat, and the third floating region 841c may be a display region used by the occupant in the front passenger seat. In addition, the second floating region 841b may be a display region commonly used by the occupants in the driver's seat and the front passenger seat.

A 3D AR image that floats to correspond to the occupant's field of view in the driver's seat is displayed in the first floating region 841a. In addition, a 3D AR image that floats to correspond to the occupant's field of view in the front passenger seat is displayed in the third floating region 841c. In addition, a 3D AR image that floats to correspond to a preset field of view, for example, a field of view preset to correspond to the driver's seat or to correspond to the front passenger seat, is displayed in the second floating region 841b.

Content items, displayed in the first, second, and third floating regions 841a, 841b, and 841c, respectively, may be controlled independently for display.

In addition, a switchable privacy mode (SPM) may be executed in such a manner that the first floating region 841a is not visible from the front passenger seat and that content displayed in the third floating region 841c is not visible from the driver's seat. In this case, 3D content may be displayed in the second floating region 841b in such a manner as to be perceived from the driver's seat and the front passenger seat.

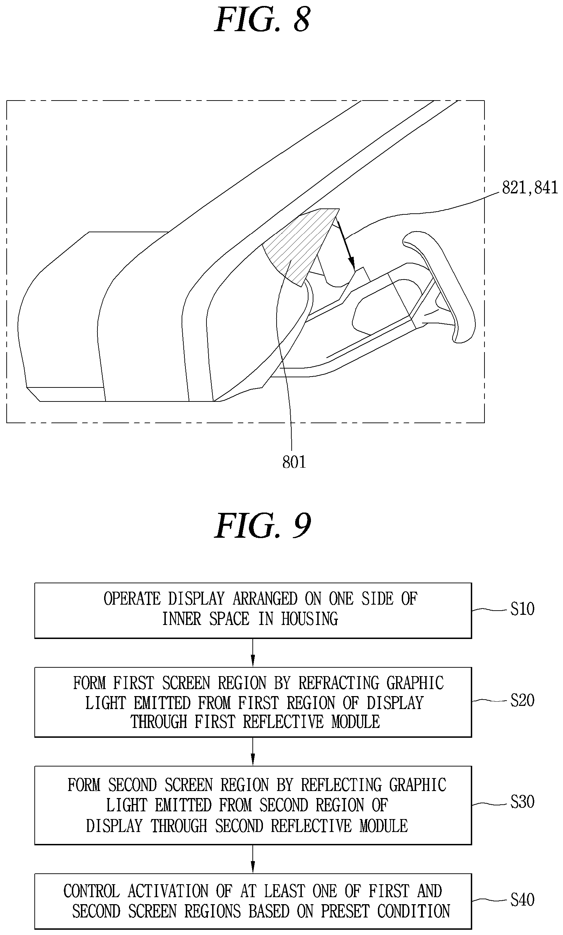

FIG. 8 is a view illustrating the vehicular display device 800 arranged in a cluster or CID region of the vehicle 100 according to the present disclosure, when viewed from the side. As illustrated in FIG. 8, the housing 801 of the vehicular display device may be arranged at a position corresponding to the dashboard in front of the driver's seat. The housing 801, for example, may be formed to be recessed inward to have an inner space in such a manner as to have a volume of approximately 23 liters.

Although not illustrated in detail, when the vehicular display device 800 is in operation, the prism display region 821 in which a real image is displayed, and the floating display region 841 in which an aerial image, that is, a 3D AR image, is displayed may be formed in the inner space in the housing 801 that is exposed within the occupant's field of view, thereby providing an eye box for the user.

When the vehicular display device 800 is not in operation, the housing 801 may be rotated or covered by the front cover so that the inner space of housing 801 is hidden from view.

The vehicular display device 800 may selectively activate the prism display region 821 and the floating display region 841 to direct the graphic light emitted from the display 810, which is arranged in the upper portion of the inner space in the housing 801, toward the user's field of view.

To this end, the vehicular display device 800 may control the display 810 in such a manner that the graphic light emitted from the first region of the display 810 is refracted through the prism and thus that a real image is displayed on the surface of the prism.

In addition, the vehicular display device 800 may control the display 810 in such a manner that the graphic light emitted from the second region of the display 810 is retracted through the prism, reflected by the 3D plate, and passes through a reflective polarized plate and/or an absorption-type polarized plate, and thus that a 3D AR image is displayed in the inner space in the housing 801 that matches the eye level of the user.

FIG. 9 is an exemplary flowchart that is referenced to describe a method of operating the vehicular display device 800 according to the present disclosure.

With reference to FIG. 9, the method of operating the vehicular display device 800 according to the embodiment of the present disclosure starts with a step of operating the display arranged on one side of the inner space in the housing 801 (FIG. 4) (S10). Graphic light is emitted from the front surface when the display 810 is in operation.

To this end, the display 810 of the vehicular display device 800 may be arranged in an upper inner portion of the inner space in the housing 801 in such a manner that the front surface thereof faces toward the ground, but may be formed to have a structure configured with a slope non-parallel with the ground.

In this manner, the display 810 is arranged in the upper inner portion of the inner space in the housing 801, thereby enabling the emitted graphic light to have a curvature and an optical path for forming an eye box. Accordingly, the optical path is formed in such a manner that the graphic light emitted from the display 810 is directed toward the 3D plate of the second reflective module 840 without being dispersed.

In addition, since the display 810 to be arranged in the upper portion is formed to have a structure inclined instead of being parallel to the ground, the floating effect of the 3D AR image appearing in the floating display region 841 formed through the second reflective module 840 is maximized.

Subsequently, the vehicular display device 800 may operate such that the graphic light emitted from the first region of the display 810 is reflected by the first reflective module 820, thereby forming the first screen region (S20).

In addition, the vehicular display device 800 may operate such that the graphic light emitted from the second region of the display 810 is reflected by the second reflective module 840, thereby forming the second screen region (S30).

In this manner, the formation of the first and second screen regions may indicate that image formation of the graphic light, emitted by operating the display 810, in any one of the first and second screen regions is completely prepared.

In this manner, when image formation in one or all of a plurality of screen regions is completely prepared, depending on whether a preset condition is satisfied, the display device 800 may control the first and second reflective modules 820 and 840 in such a manner that at least one of the first and the second screen regions formed through the first and second reflective modules 820 and 840 is activated (S40).

Specifically, for example, the first screen region formed through the first reflective module 820 may be activated to display only the vehicle driving state, thereby displaying a real image on the surface of the prism. In addition, for example, the second screen region formed through the second reflective module 840 may be activated to display a warning or alarm or to provide guidance on a hazardous situation, thereby displaying the floating 3D AR image in the inner space formed by the recess of the housing 801. At this point, the inner space formed by the recess of the side-closed housing 801 may naturally provide a darkroom effect, thereby displaying the floating 3D AR image more clearly.

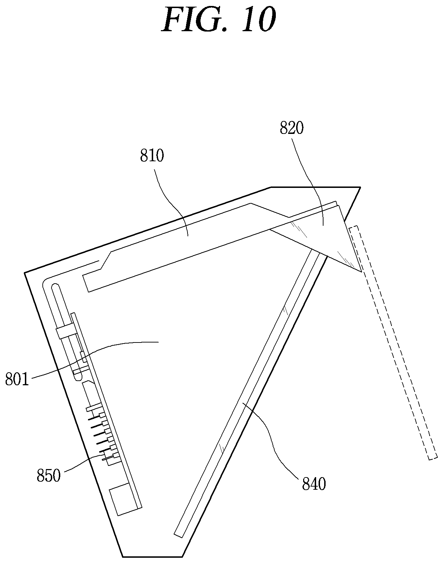

FIGS. 10, 11, and 12 are views illustrating exemplary structures of the vehicular display device 100, respectively, for executing a plurality of display modes using a single display, according to an embodiment of the present disclosure.

FIG. 10 illustrates a basic structure of the housing 801 of the vehicular display device 800. In the basic structure, the display 810 may be arranged in the upper portion of the inner space formed by the recess of the housing 801, and the processor 850 may be arranged in a rear portion of the inner space. In addition, the first reflective module 820, which is coupled to one side of the display 810 and includes the prism, is arranged to be perpendicular to the display 810 so as to align with the perpendicular direction in which light is emitted from the display 810. In addition, the second reflective module 840, which is coupled to one side of the first reflective module 820 and by which light that is refracted while passing through the prism of the first reflective module 820 is reflected, may be arranged to form a predetermined angle relative to the display 810. At this point, the second reflective module 840 may be formed to include a 3D hologram plate and a reflective mirror (not illustrated) that are arranged in the inner space in the housing 801 and formed to face a front surface of the display 810.

In an embodiment, in a state where the first reflective module 820 is activated, the processor 850 may control the first reflective module 820 in such a manner that the prism thereof refracts linearly polarized light corresponding to a graphic, the linearly polarized light being emitted from the first region of the display 810, thereby forming the first screen region.

In addition, in a state where the second reflective module 840 is activated, the processor 850 may control the second reflective module 840 in such a manner that the 3D plate thereof reflects the graphic light emitted from the second region of the display 810 or the linearly polarized light refracted through the prism, thereby forming the second region in which the 3D virtual (AR) image is displayed.

The first screen region formed through the first reflective module 820 is configured to extend over the second screen region formed through the second reflective module 840 and to the first region of the display 810.

In addition, the second screen region formed through the second reflective module 840 is formed below the first screen region formed through the first reflective module 820. 3D AR content displayed in the second screen region may be formed only within the inner space of housing 801, or a portion thereof may be formed to extend outward from the inner space.

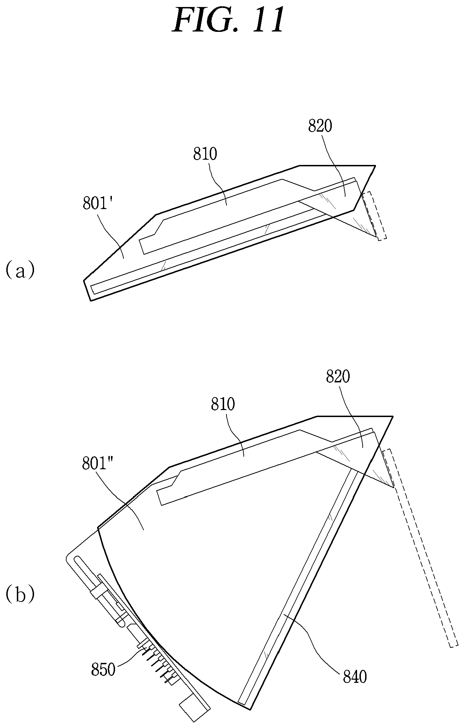

(a) of FIG. 11 illustrates an exemplary structure used only in the first screen region that is formed through the prism of the first reflective module 820 when the display 810 of the vehicular display device 800 operates. The volume of a housing 801' may be minimized in a state where, as illustrated in (a) of FIG. 11, the 3D hologram plate is folded or rotated in parallel with the display 810. The structure of the housing 801' may be referred to as a minimum slim package, and the graphic light emitted from the display 810 is refracted through the prism and is displayed as a real image on the front surface thereof. For example, in a case where the 3D hologram plate of the second reflective module is rotated, and thus an inner space in the housing 801' is reduced to the minimum, the volume of the minimum slim package may change to 9 liters.

(b) of FIG. 11 illustrates a state where the first and second reflective modules 820 and 840 are both in operation when the display 810 of the vehicular display device 800 operates, and where the first and second screen regions are correspondingly activated. At this point, the processor 850 may be arranged on an outer rear portion of the housing 801'' in such a manner as to be coupled to one side of the display 810.

In addition, according to an embodiment, a UTG plate may be coupled to the front surface of the 3D plate of the second reflective module 840, thereby forming an optical path for an eye box. In addition, although not illustrated, the vehicular display device 800 may further include a light absorption plate adjacent to the 3D plate of the second reflective 840 and additionally absorbing linearly polarized light that is not reflected by the 3D plate.

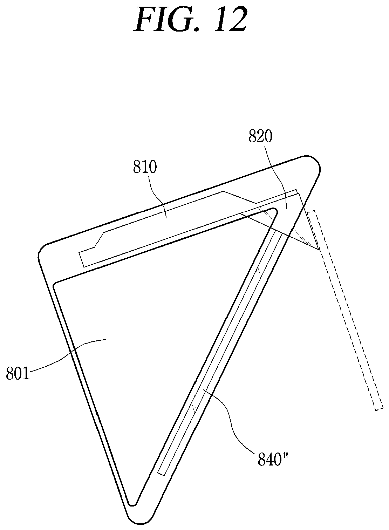

Subsequently, with reference to FIG. 12, the package of the vehicular display device 800 may be formed on the dashboard in a manner integrated with an air duct of the driver's seat of the vehicle 100, thereby having a slimmed structure. In this manner, in a case where the package is modularized with an air purifier of the vehicle, the package and the housing may be configured to have a volume of 11 liters, which is somewhat greater than the volume of the above-described minimum slim package.

As described above, in the embodiments, the vehicular display device 800 according to the embodiment of the present disclosure has the structures in which different types of graphics are displayed in the plurality of display regions using a single display.

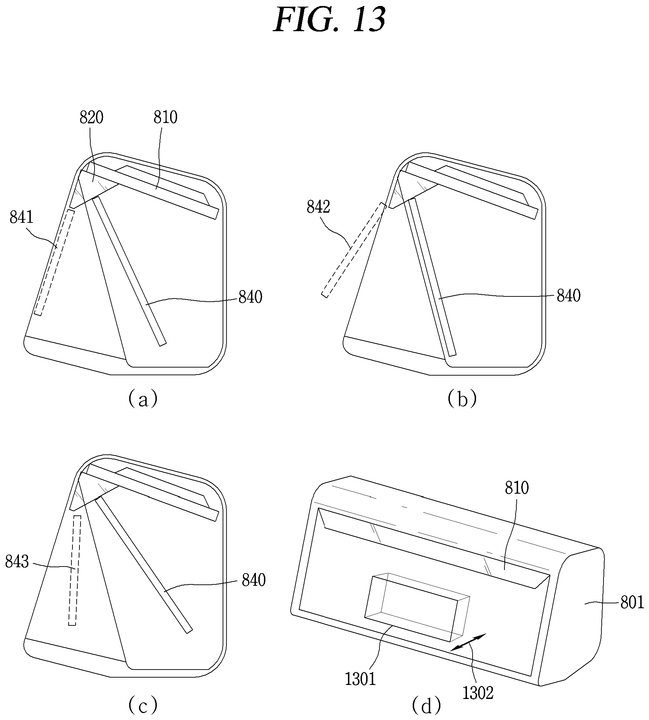

Subsequently, with reference to FIG. 13, a method of changing the position of an AR image displayed in the floating display region in the vehicular display device 800 according to the present disclosure is described in detail below.

A real image may be displayed on the surface of the prism in the first screen region formed through the first reflective module 820, and a 3D virtual (AR) image having a depth may be displayed in the second screen region formed through the second reflective module 840.

In an embodiment of the present disclosure, the 3D virtual (AR) image to be displayed in the second screen region may be displayed while moving along the X-axis, Y-axis, and Z-axis directions in the inner space in the housing 801. To this end, the 3D hologram plate of the second reflective module 840 is configured to be rotatable to adjust an inclination angle between the 3D hologram plate and the display 810.

Specifically, as illustrated in FIG. 13, the first reflective module 820 is fixed to one side of the display 810, and the second reflective module 840 is arranged to have a rotatable structure within the inner space in the housing 801. One side of the second reflective module 840 is fixed adjacent to the first reflective module 820. The second reflective module 840 is formed in such a manner that the separation distance from the display 810 progressively increases from one side toward the other side thereof. In addition, the second reflective module 840 is configured to allow the inclination angle between the second reflective module 840 and the display 810 to be adjustable by the operation of the rotation adjustment unit 860.

The processor 850 of the vehicular display device 800 may transmit a signal for adjusting the rotation of the second reflective module 840 to the rotation adjustment unit 860 in such a manner as to adjust the inclination angle between the second reflective module 840 and the display 810.

The rotation control unit 860 may include a coupling unit coupled to one side of the 3D plate of the second reflective module 840, a drive unit providing a driving force for rotating the 3D plate, and a support unit supporting the 3D plate while the 3D plate is rotated.

When the rotation control unit 860 operates in response to a driving signal transmitted from the processor 850, the 3D plate of the second reflective module 840 may rotate by a predetermined angle in a clockwise or counter-clockwise direction based on information included in the driving signal.

(a) of FIG. 13 is an exemplary view illustrating the default basic position of the second reflective module 840 in the inner space in the housing 801. In a case where the 3D plate of the second reflective module 840 is arranged at the predetermined default position, the second screen region 841, where the 3D AR content is displayed, may be displayed, for example, at an opening of the inner space in the housing 801.

In an embodiment, the processor 850 can adjust the rotation of the second reflective module 840 through the rotation control unit 860, thereby adjusting the inclination angle between the display 810 and the 3D plate. By doing so, the second screen region 841 in which the 3D AR content is displayed may be controlled in such a manner that a position thereof moves backward or forward with respect to the inner space in the housing 801.

(b) of FIG. 13 is a view illustrating an example in which the 3D plate of the second reflective module 840 rotates clockwise by a predetermined angle from the default position thereof, thereby further increasing the inclination angle between the display 810 and the 3D plate.

In this manner, when the magnitude of the inclination angle between the display 810 and the 3D plate of the second reflective module 840 increases, the position of the second screen region 841 formed through the second reflective module 840, that is, the position of the floating display region, protrudes forward. Accordingly, at least one portion of the 3D AR image to be displayed in the second screen region 841 may be displayed outward from the inner space in the housing 801.

(c) of FIG. 13 is a view illustrating an example in which the 3D plate of the second reflective module 840 rotates counterclockwise by a predetermined angle from the default position thereof, thereby further decreasing the inclination angle between the display 810 and the 3D plate.

In this manner, when the magnitude of the inclination angle between the display 810 and the 3D plate of the second reflective module 840 decreases, the position of the second screen region 841 formed through the second reflective module 840, that is, the position of the floating display region, is pushed backward, thereby displaying the second screen region 841. Accordingly, the 3D AR image to be displayed in the 2-second screen region 841 may be displayed further inside the inner space in the housing 801.

(d) of FIG. 13 is a view illustrating a state where, when the 3D plate of the second reflective module 840 rotates, a 3D AR image 1301 displayed in the second screen region, that is, in the floating display region 841, moves in a backward-forward direction 1302 in the inner space in the housing 801. At this point, a graphic displayed in the first screen region formed through the first reflective module 820, that is, in the prism display region, remains displayed on the same plane.

In this manner, the 3D AR image may move under various conditions when the position of the 3D plate of the second reflective module 840 changes.

In an embodiment, the processor 850 of the vehicular display device 800 may adjust the rotation of the second reflective module 840 in such a manner as to vary the position of the second screen region. This adjustment is based on field-of-view information (i.e., an eye box or eye level) of an occupant detected by an IMS or DMS sensor of the vehicle 100, the field-of-view information being received from the vehicle 100. To this end, the processor 850 may calculate refraction, curvature, and optical path corresponding to the field-of-view information of the occupant detected through the IMS or DMS sensor. By doing so, when operating the display 810, the processor 850 may adjust the position of the 3D plate of the second reflective module 840.

In addition, in an embodiment, when operating the display 810, the processor 850 of the vehicular display device 800 may activate the first and second screen regions formed through the first and second reflective modules 820 and 840, respectively. Subsequently, the processor 850 may display a first graphic image, which is a real image, in the first screen region 821, that is, in the prism display region. Based on the movement of a second graphic image, which is an aerial (virtual) image, displayed in the second screen region 841, that is, in the floating display region, the processor 850 may adjust the rotation of the second reflective module 840 in such a manner as to adaptively vary the position of the floating display region.

For example, in a case where the 3D AR image displayed in the floating display region is of a 3D content type configured to move backward or forward, the 3D plate of the second reflective module 840 may rotate in a manner that corresponds to such a movement pattern. Accordingly, the 3D virtual (AR) image, as illustrated in (d) of FIG. 13, may operate in such a manner as to move with respect to the inner space formed by the recess of the housing 801. To this end, the 3D plate of the second reflective module 840 may operate in such a manner as to rotate according to a pattern preset on a per-content basis.

In addition, for example, in the case of content that is effective when the 3D (AR) virtual image is displayed in such a manner as to protrude toward the driver, the position may be changed in the direction of increasing the inclination angle between the 3D plate of the second reflective module 840 and the display 810. Conversely, in the case of content that is effective when the 3D (AR) virtual image is displayed in such a manner as to be introduced into the housing 801, the position may be changed in the direction of decreasing the inclination angle between the 3D plate of the second reflective module 840 and the display 810. For example, the 3D virtual (AR) image of the second reflective module 840 may rotate clockwise or counterclockwise to create an effect where the 3D virtual (AR) image appears to be zoomed in or out. Alternatively, the 3D plate of the second reflective module 840 may be maintained in a fixed state, and the housing, including the package, may rotate in a specific direction, thereby achieving the same or similar effect.

The above-mentioned package may be configured to have a structure that is rotatable together with the dashboard of the vehicle 100. In this case, the inner space formed by the recess of the housing 801 may be exposed or closed in response to the rotation of the package. As another example, the housing 801 may further include a front cover for closing the inner space formed by the recess of the housing 801.

A method of adjusting the user's field of view for a plurality of screens, that is, the prism region and the floating region, that are formed through reflection or refraction of light from the display 810 of the vehicular display device 800 according to the embodiment of the present disclosure is described in detail below.

As described with reference to FIG. 7, the floating region 841 may be subdivided into a plurality of sub-regions. Specifically, the floating region 841 may be subdivided into a first floating region corresponding to the driver's seat, a second floating region shared by the driver and the occupant in the front passenger seat, and a third floating region corresponding to the front passenger seat.

At this point, the first and third floating regions may operate in a switchable privacy mode (SPM). Specifically, the first floating region may operate in the SPM so that only the driver can view 3D content displayed in the first floating region, but the occupant in the front passenger seat cannot view the 3D content. In addition, the third floating region may operate in the SPM so that only the occupant in the front passenger seat can view 3D content displayed in the third floating region, but the driver cannot view the 3D content.

According to the present disclosure, it may be determined on the basis of the state of the vehicle whether the SPM in the subdivided floating region is executed.

In addition, as another example, according to the present disclosure, whether to execute and/or change the SPM for the subdivided floating region may vary according to the shape (e.g., the size, a display region, and the like) and type of the 3D content to be displayed.

Moreover, according to the present disclosure, the SPM for the prism region 821 formed over the floating region, as well as the floating region, may be executed according to the state of the vehicle, and/or may be changed according to the shape, state, and type of content to be displayed.

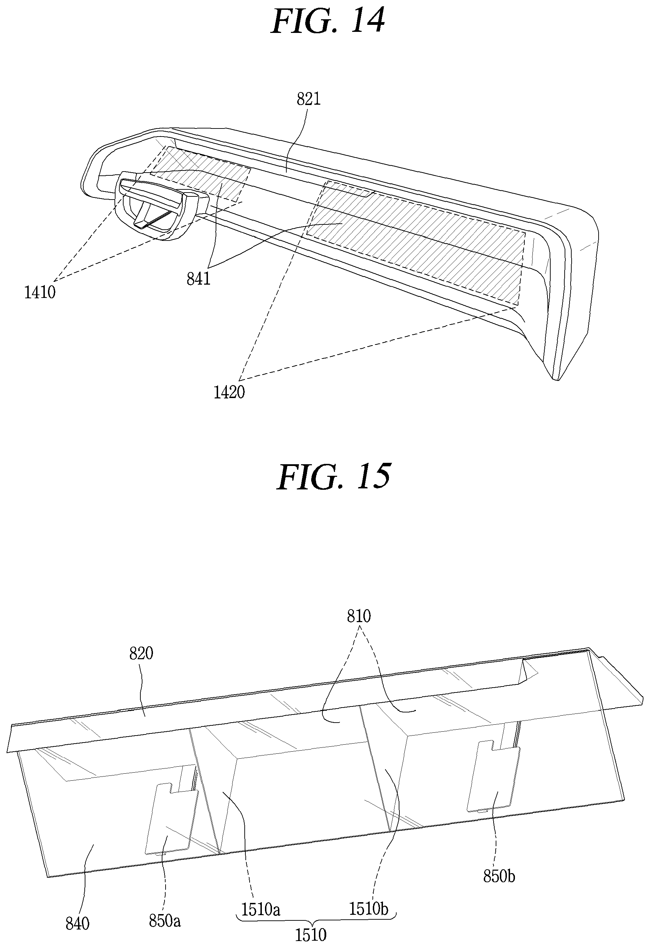

In this regard, FIG. 14 is an exemplary view that is referenced to describe the adjustment of respective fields of view of the prism region 821 and the floating region 841 that correspond to the driver's seat and the front passenger seat, respectively, in the vehicular display device 800 according to the present disclosure.

FIG. 14 illustrates that driving-related information, such as vehicle driving warnings or driving speeds, is displayed in a 'driver essential zone' on the left side of the prism region 821. When the SPM for the driver's seat is executed in the prism region 821, a field of view 1410 for the 'driver essential zone' is reduced to within a predetermined range. Accordingly, the occupant in the front passenger seat cannot perceive the driving-related information displayed in the prism region 821.

Subsequently, an environmental control menu, such as menu icons or HVAC controls, may be displayed in a 'control zone' on the right side of the prism region 821. When the SPM for the front passenger seat is executed in the prism region 821, a field of view 1420 for the 'control zone' is reduced within a predetermined range. Accordingly, from the driver's seat, the environmental control menu displayed in the prism region 821 cannot be perceived.

Whether to execute the SPM for the prism region 821 may be determined independently of the floating region 841. That is, in the vehicular display device 800 according to the embodiment of the present disclosure, whether to execute the SPM for the driver's seat and the SPM for the front passenger seat may be determined and executed independently in the prism region 821. Furthermore, whether to execute the SPM for the driver's seat and the SPM for the front passenger seat may be determined and executed independently in the floating region 841.

Subsequently, in FIG. 14, the left side of the floating region 841 may be used as the 'driver private zone' in which a warning related to the driving of the vehicle, a warning related to the state of the vehicle, the driver's profile, personal information of the driver (e.g., personal log-in information), and the like may be displayed as aerial 3D content. The displayed 3D content may vary in display position and degree of depth according to predetermined conditions (e.g., a content type, association or non-association with information displayed in the prism region, and the like). When the SPM is executed for the driver's seat in the floating region 841, the field of view for the 'driver private zone' is adjusted to a field of view 1410 reduced to within a predetermined range. Accordingly, the occupant in the front passenger seat cannot perceive 3D content information displayed in the driver private zone of the floating region 841.

The right side of the floating region 841 may be used as a 'passenger private zone' in which passenger personal information, a passenger profile, and a passenger-executed content execution screen are displayed as 3D content types. The displayed 3D content may vary in display position and degree of depth according to predetermined conditions (e.g., a content type, association or non-association with information displayed in the prism region, and the like). When the SPM for the front passenger seat is executed in the floating region 841, the field of view for the 'passenger private zone' is adjusted to a field of view 1420 reduced to within a predetermined range. Accordingly, the driver cannot perceive 3D content information displayed in the passenger private zone of the floating region 841.

In the floating region 841, a region between the 'driver private zone' and the 'passenger private zone' may be used as a 'sharing zone' in which 3D content, for example, a navigation execution screen, that is viewed by both the driver and the passenger, is displayed. The displayed 3D content may vary in display position and degree of depth according to predetermined conditions (e.g., a content type, association or non-association with information displayed in the prism region, and the like). The 'sharing zone' is a region that is always shared in the floating region 841, regardless of whether the SPM for the front passenger seat and/or the driver's seat is executed. Therefore, both the driver and the passenger can always perceive 3D content information displayed in the 'sharing zone.'

A structure for independently executing various SPMs, as described above, on a per-region basis is described hereinafter. To this end, reference is made back to FIGS. 3 and 4.

The display 810 may be arranged in the upper portion of the inner space formed by the recess of the housing 801 of the vehicular display device 800, and the display 810 may be arranged to be inclined by a predetermined angle in a manner non-parallel with the ceiling.

The communication unit 830 of the vehicular display device 800 may receive state information by communicating with the vehicle 100. At this point, the state information includes not only state information of the vehicle itself and driving state information of the vehicle, but also situation information inside the vehicle and situation information outside (surrounding) the vehicle, each of which is detected by a sensor included in the vehicle. For example, the state information received through the communication unit 830 includes the presence, emotional states, gestures, and the like of the driver and the occupant, which are detected through an internal camera of the vehicle.

The prism region 821, as described above, is the first screen region that is formed as a result of light emerging from the display 810 being refracted through the prism of the first reflective module 820. The prism region 821 may operate in the SPM at respective positions of the driver and the passenger, and each field of view of the driver and the passenger may be reduced to within a predetermined range (operation in the SPM), or may be adjusted to reach or exceed a predetermined range.

The floating region 841, as described above, is a second screen region that is formed as a result of light emerging from the display 810 being reflected by the 3D plate of the second reflective module 840 or being reflected by the 3D plate after undergoing refraction through the prism. The floating area 841 operates in the SPM at respective positions of the driver and the passenger, and each field of view of the driver and the passenger may be reduced to within a predetermined range (operation in the SPM) or may be adjusted to reach or exceed a predetermined range.

Although not directly illustrated in FIGS. 3 and 4, the processor 850 may include a field-of-view adjustment module for adjusting a field of view on a per-user basis in a plurality of screen regions. Specifically, a portion of the field-of-view adjustment module may be included in the processor 850, and a portion or all portions of the field-of-view adjustment module may operate in conjunction with the processor 850.

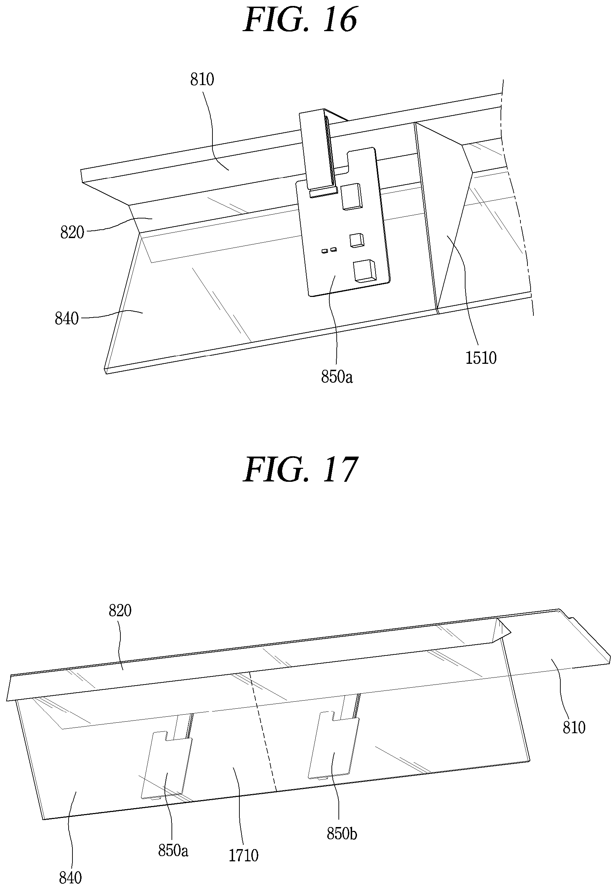

A field-of-view adjustment module 1510 or 1710 may be formed to have a partition-type structure as illustrated in FIG. 15, or formed to have a film-type structure as illustrated in FIG. 17. The formation of these structures is described in more detail below with reference to FIGS. 15 and 17.

The field-of-view adjustment module may be arranged to correspond to the front surface of the display 810. At this point, the arrangement to correspond to the front surface of the display 810 includes (a) attaching at least one portion of the field-of-view adjustment module to the front surface of the display 810, (b) arranging one portion of the field-of-view adjustment module on the front surface of the 3D plate, and (c) arranging one portion of the field-of-view adjustment module on the front surface of the display 810 vertically or inclinedly. That is, the field-of-view adjustment module may be arranged so that some portion or all portions of light (e.g., side light) emerging in a specific direction from the display 810 are blocked.

In response to the operation of the processor 850, the field-of-view adjustment module may adjust a field of view in such a manner that light emitted from the display 810 emerges within a predetermined range of angles.

Specifically, when operating the display 810, the processor 850 may control the driving of the field-of-view adjustment module on the basis of the state information received from the vehicle 100 in such a manner that the fields of view for the first and second screen regions, that is, for the prism region and the floating region are varied.

At this point, in response to a driving signal generated by the processor 850, the field-of-view adjustment module may adjust fields of view for a plurality of sub-regions of the first reflective module 820 for each of the driver and the passenger, and fields of view for a plurality of sub-regions of the second reflective module 840 for each of the driver and the passenger.

In an embodiment, the field-of-view adjustment module may employ a structure that is coupled, as a type of partition or film, to the prism of the first reflective module 820 or the 3D plate of the second reflective module 840.

In another embodiment, the field-of-view adjustment module may be configured to include a plurality of field-of-view adjustment modules, for example, a first field-of-view adjustment module and a second field-of-view adjustment module, to execute the SPM (hereinafter referred to as a 'private mode') independently in each of a plurality of screen regions.

Specifically, in the embodiment, the field-of-view adjustment module may include the first field-of-view adjustment module, arranged on the 3D plate of the second reflective module 840 to correspond to a first sub-region corresponding to the driver's seat, and a second field-of-view adjustment module, arranged on the 3D plate thereof to correspond to a second sub-region corresponding to the front passenger seat.

In this case, the processor 850 controls each of the first and second field-of-view adjustment modules on the basis of the state information received from the vehicle 100 in such a manner that a field of view for each of the first and second sub-regions remains within a predetermined range of angles or reaches or exceeds the predetermined range of angles. To this end, the processor 850 may be configured to have a structure that includes first and second processors corresponding to the first and second field-of-view adjustment modules, respectively, for control.

The processor 850 may control the field-of-view adjustment module on the basis of the state information received from the vehicle and may adjust the fields of view for the plurality of screen regions, corresponding to the driver and/or the front passenger seat, to within a predetermined range or to reach or exceed the predetermined range.

In an embodiment, the processor 850 may control the field-of-view adjustment module in such a manner that, in a first vehicle state, light emitted from the display 810 emerges to reach or exceed the predetermined range of angles. Specifically, the processor 850 may control the first and second field-of-view adjustment modules in such a manner that, in the first vehicle state, light emitted from the display 810 emerges from the prism region and/or the floating region, corresponding to the driver's seat, and/or from the prism region and/or the floating region, corresponding to the front passenger seat, to reach or exceed the predetermined range of angles.

At this point, the first vehicle state may be a state that does not require private protection of the driver and/or the passenger, and/or does not interfere with driving. For example, the first vehicle state may refer to the case where only the driver or the passenger is present in the driver's seat or the front passenger seat, the case where the vehicle is in the autonomous driving mode, or an equivalent case.

In addition, in an embodiment, the processor 850 may control the field-of-view adjustment module in such a manner that, in a second vehicle state, light emitted from the display 810 emerges only within the predetermined range of angles. Specifically, the processor 850 may control the first and second field-of-view adjustment modules in such a manner that, in the second vehicle state, light emitted from the display 810 emerges from the prism region and/or the floating region, corresponding to the driver's seat, and/or from the prism region and/or the floating region, corresponding to the front passenger seat, within the predetermined range of angles.

At this point, the second vehicle state may be a state that requires private protection of the driver and/or passenger, and/or causes concern of interference with driving. For example, the second vehicle state may refer to the case where, when the display 810 is in operation, both the driver and the passenger are present in the driver's seat or the front passenger seat, respectively, a case where the vehicle is in the manual driving mode, or an equivalent case.

As described above, the state information of the vehicle may be included as one of the conditions for operating the field-of-view adjustment module.

In an embodiment, the state information of the vehicle, received from the vehicle 100, may include occupant information sensed through the internal camera of the vehicle. In this case, the first vehicle state may be a state where an occupant in the front passenger seat is not detected, and the second vehicle state may be a state where an occupant in the front passenger seat is detected.

The processor 850 may control the field-of-view adjustment module based on the detection of the occupant in the front passenger seat of the vehicle in such a manner that, when the display 810 is in operation, the field of view for the prism region and/or floating region, corresponding to the front passenger seat, and/or the field of view for the prism region and/or floating region, corresponding to the driver's seat are adjusted to within a predetermined range of angles. At this point, the predetermined range of angles, for example, may be a range of ±45 to ±60 degrees vertically and/or horizontally.

In another embodiment, the state information of the vehicle, received from the vehicle 100, may include information about a driving mode of the vehicle. In this case, the first vehicle state may be a state in which the vehicle is in the autonomous driving mode or in a stationary state, and the second vehicle state may be a state in which the vehicle operates in the manual driving mode.

The processor 850 may control the field-of-view adjustment module based on the operation of the vehicle in the manual driving mode in such a manner that, when the display 810 is in operation, the field of view for the prism region and/or floating region, corresponding to the front passenger seat, is adjusted to within a predetermined range of angles. At this point, the predetermined range of angles, for example, may be a range of ±45 to ±60 degrees vertically and/or horizontally. The predetermined range of angles may be pre-stored in the memory and may be variable according to a setting/input or under the control of the processor 850.

As described above, the vehicular display device according to the embodiment of the present disclosure may selectively execute a privacy mode for real and aerial images, displayed in front of each of the driver's seat and the front passenger seat, on the basis of the state of the vehicle.

A method of adjusting the fields of view for the prism region and the floating region through the field-of-view adjustment module 1510, formed as a type of partition, is described in detail below with reference to FIGS. 15 and 16.

With reference to FIG. 15, a plurality of transparent partitions, for example, transparent partitions 1510a and 1510b, for adjusting the fields of view from the driver's seat and the front passenger seat, may be coupled to the 3D plate of the second reflective module 840. With reference to FIGS. 15 and 16, the plurality of transparent partitions, for example, the transparent partitions 1510a and 1510b, may be arranged not only to partition the 3D plate of the second reflective module 840 into a plurality of sub-regions, but also to partition the prism of the first reflective module 820 into a plurality of sub-regions.

The plurality of transparent partitions, for example, the transparent partitions 1510a and 1510b, are arranged to correspond to the front surface of the display 810 and are formed in a manner that is longitudinally spaced apart by a predetermined distance. With reference to FIG. 15, the first transparent partition 1510a is positioned at the 1/3 point of the display 810 (or at the 2/3 point), and the second transparent partition 1510b is positioned at the 2/3 point of the display 810 (or at the 1/3 point).

One side of each of the plurality of transparent partitions, for example, the transparent partitions 1510a and 1510b, may be arranged to come into contact with the display 801, and the other side may be arranged to come into contact with one portion of each of the first and second reflective modules 820 and 840.

The processor 850 determines, on the basis of the state information received from vehicle 100, whether to drive the field-of-view adjustment module and the plurality of transparent partitions, the transparent partitions 1510a and 1510b. In response to a driving signal (e.g., a voltage application signal or the like), generated by the determination by the processor 850, each of the plurality of transparent partitions, for example, transparent partitions 1510a and 1510b, blocks side light emitted from the display 810, thereby allowing light emitted from the display 810 to emerge within a predetermined range of angles or to emerge to reach or exceed the predetermined range of angles.

In an embodiment, one shaft of each of the plurality of transparent partitions, for example, the transparent partitions 1510a and 1510b, may be coupled to the display 810. In this case, a protective layer and an adhesive layer may be additionally arranged between the display 810 and each of the plurality of transparent partitions, for example, the transparent partitions 1510a and 1510b.

In an embodiment, in the second screen region, that is, the floating region, among the plurality of transparent partitions, a first transparent partition 1510a may be arranged between the first sub-region for the driver's seat and the second sub-region for sharing. In addition, in the second screen region, that is, the floating region, among the plurality of transparent partitions, a second transparent partition 1510b may be arranged between the second sub-region and a third sub-region for the front passenger seat.

In this case, the processor 850 may control the field-of-view adjustment module on the basis of the state information received from the vehicle 100 in such a manner that at least one of the first and second transparent partitions 1510a and 1510b blocks side light emitted from the display 810, thereby adjusting the field of view for at least one of the first and third sub-regions.

In an embodiment, each of the plurality of transparent partitions, for example, the transparent partitions 1510a and 1510b, may be filled with a light-blocking material. Each of the plurality of transparent partitions, for example, the transparent partitions 1510a and 1510b, may open a path for light emerging from the display 810 or block a path for the light in a specific direction under the control of the processor 850.

In a case where a lateral surface at a position corresponding to the driver's seat and/or the front passenger seat is blocked by the plurality of transparent partitions, for example, the transparent partitions 1510a and 1510b, only a driver in the driver's seat can perceive information displayed in the prism region and the floating region, and the other occupant cannot view the displayed information. Similarly, only an occupant in the front passenger seat can perceive the information displayed on the prism region and the floating region, and the other occupant cannot view the displayed information.

With reference to FIGS. 15 and 16, a first processor 850a determines, in conjunction with the first transparent partition 1510a, whether to execute the SPM for the screen region (the prism region and/or the floating region) corresponding to the driver's seat, and enables the first transparent partition 1510a to perform an operation in accordance with the determination.

A second processor 850b determines, in conjunction with the second transparent partition 1510b, whether to execute the SPM for the screen region (the prism region and/or the floating region) corresponding to the front passenger seat, and enables the second transparent partition 1510b to perform an operation in accordance with the determination.

The first and second transparent partitions 1510a and 1510b may have a predetermined width and height and may be arranged to be spaced apart by a predetermined distance.

The first and second transparent partitions 1510a and 1510b may be formed of transparent resin. To this end, the first and second transparent partitions 1510a and 1510b may be manufactured by a process such as silk screening, embossing, photolithography, and/or imprinting.

The first and second transparent partitions 1510a and 1510b may be formed of a transparent light-transmitting material. In this case, the light-transmitting material may be composed, for example, of light-curable resin, such as UV resin or photoresist resin, or may be composed of at least one of the following: urethane resin or acrylic resin.

The first and second transparent partitions 1510a and 1510b are illustrated as being arranged perpendicularly to the display 810, and without being limited thereto, may be arranged to be inclined so as to form a predetermined angle with respect to the display 810.

The processor 850 may operate to facilitate the transmission of light incident on the first and second transparent partitions 1510a, 1510b, or to block one portion of light emerging in a specific direction. Specifically, the first processor 850a may operate in conjunction with the first transparent partition 1510a and thus may block side light in such a manner that information to be displayed in the prism region and the floating region corresponding to the driver's seat has a field of view within a predetermined range of angles. In addition, the second processor 850b may operate in conjunction with the second transparent partition 1510b and thus may block side light in such a manner that information to be displayed in the prism region and the floating region corresponding to the driver's seat has a field of view within a predetermined range of angles. Information to be displayed in the prism region and the floating region corresponding to a sharing region between the first and second transparent partitions 1510a and 1510b is not blocked, and may be perceived from both positions corresponding to the driver's seat and the front passenger seat.

In this manner, the independent driving of the first and second transparent partitions 1510a and 1510b by the first and second processors 850a and 850b may be performed on the basis of the state information (e.g., the detection or non-detection of an occupant in the front passenger seat, a vehicle driving mode, or the like) received from the vehicle.

In addition, in some embodiments, the independent driving of the first and second transparent partitions 1510a and 1510b by the first and second processors 850a and 850b may be performed in a manner that varies according to a type of content to be displayed in a plurality of prism regions and a plurality of floating regions formed through the first and second reflective modules 820 and 840.

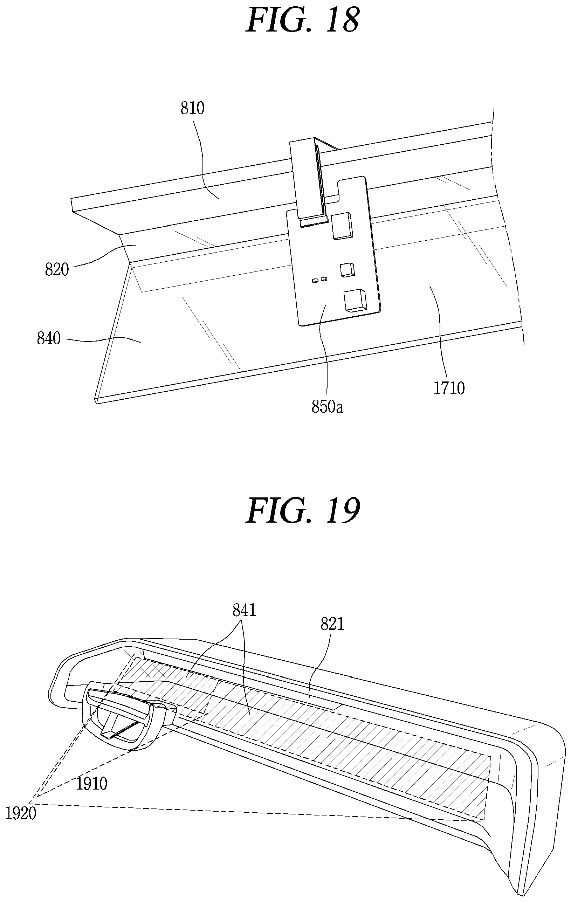

With reference to FIGS. 17 and 18, the method of adjusting the field of view for the prism region and the floating region through the field-of-view adjustment module 1520, formed as a type of film, is described in detail below.

With reference to FIG. 17, a field-of-view adjustment film 1710 for adjusting a field of view at the driver's seat and the front passenger seat may be coupled to the 3D plate of the second reflective module 840. With reference to FIGS. 17 and 18, the field-of-view adjustment film 1710 is formed to be divided into a plurality of sub-regions, and thus may be arranged in such a manner that the prism of the first reflective module 820, as well as the 3D plate of the second reflective module 840, may be partitioned into a plurality of sub-regions. In this case, the field-of-view adjustment film matching the plurality of sub-regions, resulting from the partitioning, may operate in conjunction with different processors, for example, the first and second processors 850a and 850b.

In an embodiment, the field-of-view adjustment module, that is, the field of view adjustment film 1710, may adjust a field of view on the basis of voltage applied to a plurality of electrodes arranged on the display 810 in such a manner that light emitted from the display 810 emerges within a predetermined range of angles or emerges to reach or exceed the predetermined range of angles.

To this end, the processor 850 may determine, on the basis of the state information received from the vehicle 100, whether to block light that deviates from the predetermined range of angles, that is, whether to execute the SPM. Based on the determination, the processor 850 may control the application of varied voltage to a plurality of electrodes of the field-of-view adjustment module.

The field-of-view control adjustment film arranged for adjusting a field of view may be formed to have a structure in which a plurality of films, for example, first and second films, a light conversion layer, and an adhesive layer are deposited on top of each other.

The processor 850 may operate to adjust the magnitude of an electric field by applying or not applying voltage to the light conversion layer. To this end, a first film may include a first electrode, and a light conversion layer and a plurality of adhesive layers may be deposited on the first film. A second film, which includes a second electrode, is sequentially arranged on top of the plurality of adhesive layers in a manner that faces the first film. In this case, the first and second electrodes may each include a transparent conductive material.

Through this film structure, light emerging in a specific direction, for example, one portion of side light may be blocked in such a manner that light emerges only within a predetermined range of angles from the display 810.

Specifically, the processor 850 controls the application of voltage to the first and second electrodes. Thus, when an electric field is formed between the first and second films, light emerges from the display 810 to reach or exceed a predetermined range of angles. In addition, the processor 850 controls the non-application of voltage to the first and second electrodes. Thus, when an electric field is not formed between the first and second films, light emerges within the predetermined range of angles from the display 810, and the SPM is executed.

In this manner, when an electric field is not formed between the first film and the second film, the prism region and/or the floating region operate in the SPM. The operation in the SPM is because light-blocking particles included in the first and second films block light (e.g., side light) that emerges in a specific direction from the display 810.

The light conversion layer arranged between the first and second films includes light-blocking particles. In this manner, the light-blocking particles enable carbon particles, absorbing light, to block light, thereby enabling the operation in the SPM. The light-blocking particles move in one direction when an electric field is formed. Thus, carbon particles fail to block the light, allowing light emerging from the display 810 to have a field of view that reaches or exceeds a predetermined range of angles.

According to the present disclosure, a plurality of films are generated that are independently controllable on the basis of each of the plurality of sub-regions of the prism region 821 and/or on the basis of each sub-region of the floating region 841, which corresponds to the driver's seat and the front passenger seat. Thus, when the display 810 is in operation, the SPM may be executed or may not be executed on the basis of each sub-region.

In another embodiment, voltage is applied to the electrodes of the field-of-view adjustment modules corresponding to the plurality of sub-regions of the prism region 821 and the plurality of sub-regions of the floating region 841. The processor 850 may adjust the voltage in a manner that varies in magnitude. Accordingly, a range of fields of view for the screen region that operates in conjunction with each field-of-view adjustment module may be adjusted independently and variably.

In an embodiment, the processor 850 operates on the basis of the state information received from the vehicle in such a manner that voltage is not applied to a plurality of electrodes associated with the field-of-view adjustment film in a first operation mode (i.e., the SPM) in which light deviating from the predetermined range of angles is blocked.

In addition, the processor 850 may control, on the basis of the state information received from the vehicle, the application of a preset voltage to the plurality of electrodes associated with the field-of-view adjustment film in a second operation mode in which the light deviating from the predetermined range of angles is not blocked.

As described above, the first and second screen regions formed through the first and second reflective modules 820 and 840, respectively, may each be divided into the first sub-region for the driver's seat, the second sub-region for sharing, and the third sub-region for the front passenger seat.

In this case, the field-of-view adjustment module, that is, the field-of-view adjustment film 1710, may be formed to include a first plurality of electrodes for adjusting a field of view for the first sub-region and a second plurality of electrodes for adjusting a field of view for the third sub-region.

In addition, in an embodiment, the processor 850 may independently control voltage to be applied to the first plurality of electrodes and the second plurality of electrodes on the basis of the state information received from the vehicle in such a manner that the fields of view for the first and third sub-regions are controlled.

Specifically, as illustrated in FIGS. 17 and 18, the first processor 850a determines, in conjunction with the left side of the field-of-view adjustment film 1710, whether to execute the SPM for the screen region (the prism region and/or the floating region) corresponding to the driver's seat, and enables the left side of the field-of-view adjustment film 1710 to perform an operation in accordance with the determination.

For example, the first processor 850a may control the field of view for the screen region corresponding to the driver's seat (the prism region and/or the floating region) in such a manner as to reach or exceed a predetermined range of angles by applying voltage to a plurality of electrodes arranged on the left side of the field-of-view adjustment film 1710 and thus forming an electric field. In addition, for example, the first processor 850a may control the field of view for the screen region (the prism area and/or floating region) corresponding to the driver's seat in such a manner as to remain within a predetermined range of angle for the operation in the SPM, not by applying voltage to a plurality of electrodes arranged on the left side of the field-of-view adjustment film 1710.

In addition, for example, the second processor may control the field of view for the screen region (the prism region and/or the floating region) corresponding to the front passenger seat in such a manner as to reach or exceed a predetermined range of angles by applying voltage to a plurality of electrodes arranged on the right side of the field-of-view adjustment film 1710. In addition, for example, the second processor may control the field of view for the screen region (the prism region and/or the floating region) corresponding to the front passenger seat in such a manner as to remain within a predetermined range of angles, not by applying voltage to a plurality of electrodes arranged on the right side of the field-of-view adjustment film 1710.

As described above, the vehicular display device according to the embodiment of the present disclosure may independently and selectively perform the privacy mode for real and aerial images displayed in front of each of the driver seat and the front passenger seat on the basis of the vehicle state, using the partition-type field-of-view adjustment module and the film-type field-of-view adjustment module.

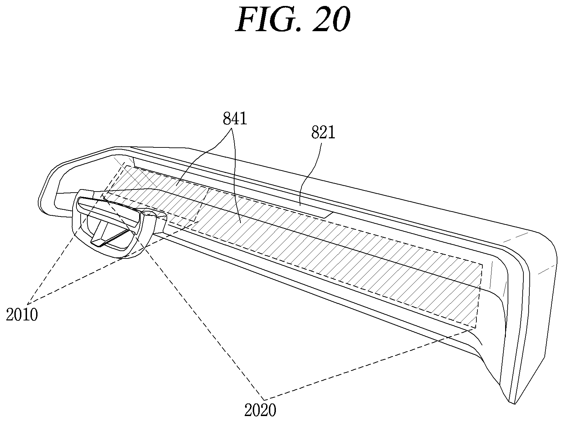

FIG. 19 is a view illustrating that the field of view for the driver's seat is adjusted through the vehicular display device according to the embodiment of the present disclosure. FIG. 20 is a view illustrating that the field of view for the front passenger seat is adjusted through the vehicular display device.

Specifically, FIG. 19 illustrates a range of fields of view within which an occupant in the driver's seat can perceive displayed information, depending on whether the SPM for the front passenger seat is executed. In addition, FIG. 20 illustrates a range of fields of view that a passenger in the front passenger seat can perceive displayed information, depending on whether the SPM for the driver's seat is executed.

With reference to FIG. 19, when the SPM for the prism region 821 and/or the floating region 841 corresponding to the front passenger seat is executed, the driver can perceive information displayed in the prism region 821 and/or the floating region 841 using a field of view 1910 within a predetermined angular range. In this case, the driver cannot perceive the information displayed in the prism region 821 and the floating region 841, corresponding to the front passenger seat, from the driver's position.

Similarly, while the SPM for the prism region 821 and/or the floating region 841 corresponding to the front passenger seat is not executed, the driver can perceive the information displayed in the prism region 821 and/or the floating region 841 using a field of view 1920 that reaches or exceeds a predetermined angular range. In this case, the driver can also view the information displayed in the prism region 821 and/or the floating region 841 corresponding to the passenger seat from the driver's position.

Subsequently, with reference to FIG. 20, when the SPM corresponding to the prism region 821 and/or the floating region 841 corresponding to the driver's seat is executed, a passenger in the front passenger seat can perceive the information displayed in the prism region 821 and/or the floating region 841 using a field of view 2010 within a predetermined angular range. In this case, the passenger in the front passenger seat cannot view information displayed in the prism region 821 and/or the floating region 841, corresponding to the driver's seat, from the driver's position.

Similarly, while the SPM for the prism region 821 and/or the floating region 841 corresponding to the driver's seat is not executed, the passenger in the front passenger seat can perceive the information displayed in the prism region 821 and/or the floating region 841 using a field of view 2020 that reaches or exceeds a predetermined angular range. In this case, the passenger in the front passenger seat can view the information displayed in the prism region 821 and the floating region 841, corresponding to the driver's seat, from the driver's position.

The processor 850 may adjust the predetermined range of angles on the basis of the occupant information received from the vehicle 100 in such a manner as to match the position and posture of the driver in the driver's seat and the passenger in the front passenger seat.

As described above, the vehicular display device according to the embodiment of f the present disclosure can execute selectively or simultaneously a plurality of different display modes using a single display module. For example, a real image or an aerial image may be displayed selectively or simultaneously using only a single display. In addition, the position of the 3D virtual image that floats according to a content type or content movement can vary with the user's field of view, thereby displaying a graphic image in such a manner that the 3D virtual image remains within the user's field of view and that a sense of immersion and a floating effect are maximized. In addition, the privacy mode can be executed, on the basis of the vehicle state, for a real image and an aerial image displayed in front of each of the driver's seat and the front passenger seat. Specifically, while the display is in operation, the privacy mode may be executed for a plurality of screens displayed in front of the front passenger seat. In addition, during the manual driving of the vehicle, the privacy mode may be executed for a plurality of screens displayed in front of the front passenger seat to ensure that the driver's driving is not disturbed. In addition, during vehicle driving, for the protection of driver privacy, the privacy mode can also be executed for a plurality of screens displayed in front of the driver's seat. In this manner, the field of view for each of the driver's seat and the front passenger seat can be adjusted according to the state of the vehicle in such a manner as to reach or exceed a predetermined range or to remain within the predetermined range.

The present disclosure may be implemented in the form of computer-readable code recorded on a program-recorded medium. Computer-readable media include all types of recording devices capable of storing data that are readable by a computer system. Examples of computer-readable media include hard disk drives (HDDs), solid-state disks (SSDs), silicon disk drives (SDDs), ROM, RAM, CD-ROM, magnetic tapes, floppy disks, optical data storage devices, and other similar media. In addition, these media may further include transmission media, such as waves (e.g., waves transmitted over the Internet). In addition, the computer may also include a processor of the vehicular display device 800. Therefore, the detailed description should not be construed as limiting in any respect, but should be regarded as illustrative in nature. The scope of the present disclosure should be determined by the proper interpretation of the following claims. All equivalent modifications to the embodiments of the present disclosure fall within the scope of the present disclosure.

## Claims

1. A vehicular display device (800) comprising:
a housing (801) recessed to form an inner space inside;
a display (810) arranged in an upper portion of the inner space in the housing (801);
a communication module receiving state information from a vehicle;
a first reflective module (820) coupled to one side of the display (810) in the inner space and arranged in such a manner that graphic light emitted from a first region of the display (810) forms a first screen region (821) after refraction;
a second reflective module (840) coupled to one side of the first reflective module (820) in the inner space and arranged in such a manner that graphic light emitted from a second region of the display (810) forms a second screen region (841) after reflection; and
a field-of-view adjustment module (1510) arranged in a manner that corresponds to a front surface of the display (810), and adjusting a field of view in such a manner that light emitted from the display (810) emerges within a predetermined range of angles; and
a processor (850) electrically coupled to the display (810), the first and second reflective modules (820, 840), and the field-of-view adjustment module (1510), and controlling each operation thereof,
wherein the field-of-view adjustment module (1510) adjusts a field of view on the basis of voltage applied to a plurality of electrodes arranged on the display (810) in such a manner that light emitted from the display (810) emerges within a predetermined range of angles or emerges to reach or exceed the predetermined range of angles, and
wherein, when operating the display (810), the processor (850) controls the driving of the field-of-view adjustment module (1510) on the basis of the received state information in such a manner that fields of view for the first and second screen regions (821, 841) vary, and
determines, on the basis of the received state information, whether to block light that deviates from the predetermined angle range and, based on the determination, controls the application of varied voltage to a plurality of electrodes of the field-of-view adjustment module (1510).

2. The vehicular display device (800) of claim 1, wherein the first reflective module (820) includes a prism,
wherein the second reflective includes a 3D plate that extends from one side of the prism and is arranged to face the display (810) at a predetermined angle with respect to the display (810), and
wherein the field-of-view adjustment module (1510) employs a structure that is coupled, as a type of partition or film, to the prism or the 3D plate.

3. The vehicular display device (800) of claim 2, wherein the field-of-view adjustment module (1510) comprises:
a first field-of-view adjustment module, arranged on the 3D plate to correspond to a first sub-region corresponding to a driver's seat of the vehicle; and
a second field-of-view adjustment module, arranged on the 3D plate to correspond to a second sub-region corresponding to a front passenger seat of the vehicle, and
wherein the processor (850) controls the first and second field-of-view adjustment modules on the basis of the received state information in such a manner that a field of view for each of the sub-regions remains within a predetermined range of angles or reaches or exceeds the predetermined range of angles.

4. The vehicular display device (800) of claim 1, wherein, on the basis of the state information received from the vehicle, the processor (850) controls the field-of-view adjustment module (1510) in a first vehicle state in such a manner that light emitted from the display (810) emerges to reach or exceed the predetermined range of angles, and controls the field-of-view adjustment module (1510) in a second vehicle state in such a manner that the light emitted from the display (810) emerges within the predetermined range of angles.

5. The vehicular display device (800) of claim 4, wherein the state information received from the vehicle includes occupant information sensed through an internal camera (220) of the vehicle,
wherein the first vehicle state is a state in which an occupant in a front passenger seat of the vehicle is not detected, and
wherein the second vehicle state is a state in which the occupant in the front passenger seat is detected.

6. The vehicular display device (800) of claim 5, wherein the state information received from the vehicle further includes driving mode information of the vehicle, and
wherein the second vehicle state is a state in which the vehicle operates in a manual driving mode.

7. The vehicular display device (800) of claim 1, wherein the field-of-view adjustment module (1510) includes a plurality of transparent partitions (1510a, 1510b) formed on the display (810) in a manner that is spaced apart by a predetermined distance, and
wherein the processor (850) determines, on the basis of the received state information, whether to drive the field-of-view adjustment module (1510), and, based on the determination, controls the emerging of light within a predetermined range of angles by blocking side light emitted from the display (810) using the plurality of transparent partitions (1510a, 1510b).

8. The vehicular display device (800) of claim 7, wherein the plurality of transparent partitions (1510a, 1510b) comprises:
a first transparent partition arranged between a first sub-region for a driver's seat and a second sub-region for sharing, in the second screen region (841); and
a second transparent partition arranged between the second sub-region and a third sub-region for a front passenger seat in the second screen region (841).

9. The vehicular display device (800) of claim 8, wherein the processor (850) controls the field-of-view adjustment module (1510) on the basis of the received state information in such a manner that at least one of the first and second transparent partitions (1510a, 1510b) blocks side light emitted from the display (810), thereby adjusting a field of view for at least one of the first and third sub-regions.

10. The vehicular display device (800) of claim 1, wherein the processor (850) does not apply voltage to the plurality of electrodes on the basis of the received state information in a first operation mode in which light deviating from the predetermined range of angles is blocked, and
wherein the processor (850) controls the field-of-view adjustment module (1510) on the basis of the received state information in such a manner as to apply a preset voltage to the plurality of electrodes in a second operation mode in which the light deviating from the predetermined range of angles is not blocked.

11. The vehicular display device (800) of claim 10, wherein the first and second screen regions (821, 841) each are divided into a first sub-region for a driver's seat, a second sub-region for sharing, and a third sub-region for a front passenger seat, and
wherein the field-of-view adjustment module (1510) includes a first plurality of electrodes for adjusting a field of view for the first sub-region, and a second plurality of electrodes for adjusting a field of view for the third sub-region.

12. The vehicular display device (800) of claim 11, wherein the processor (850) controls voltage to be applied to the first plurality of electrodes and the second plurality of electrodes on the basis of the received state information in such a manner that the fields of view for the first and second sub-regions are controlled.
